# EUROPEAN PATENT APPLICATION

(11) **EP 3 460 845 A1**
(43) Date of publication of application: **27.03.2019**
(21) Application number: 18195847.1
(22) Date of filing: 28.06.2011
(51) Int. Cl.: H01L 27/06, H01L 27/11578, H01L 27/11551, H01L 27/11524, H01L 27/11529

(54) **A 3D SEMICONDUCTOR DEVICE AND SYSTEM**

(30) Priority: 30.07.2010 US 84791110; 03.08.2010 US 84927210; 19.08.2010 US 85966510; 30.09.2010 US 89425210; 07.10.2010 US 90037910; 11.10.2010 US 90189010; 13.10.2010 US 90410810; 13.10.2010 US 90411910; 07.11.2010 US 94107510; 07.11.2010 US 94107410; 07.11.2010 US 94107310; 18.11.2010 US 94961710; 22.11.2010 US 95192410; 22.11.2010 US 95191310; 16.12.2010 US 97060210; 28.01.2011 US 201113016313; 06.03.2011 US 201113041405; 06.03.2011 US 201113041406
(62) Divisional of application: 11812914.7
(71) Applicant: Monolithic 3D Inc., San Jose, California 95124 (US)
(72) Inventor: Or-Bach, Zvi, San Jose, California 85124 (US); Sekar, Deepak C., Sunnyvale, California 94087 (US); Cronquist, Brian, Klamath Falls, Oregon 97601 (US)
(74) Representative: Harrison IP Limited

(57) **Abstract**

A 3D semiconductor device, the device including: a plurality of first transistors, overlaid by a plurality of second memory cells, overlaid by a plurality of third memory cells, overlaid by a plurality of fourth memory cells, where the second memory cells, the third memory cells and the fourth memory cells are self-aligned, having been processed following the same lithography step, and where a periphery circuit includes at least one of the first transistors and the periphery circuit controls at least one of the second memory cells, at least one of the third memory cells and at least one of the fourth memory cells, and where at least one of the second memory cells includes second transistors, at least one of the second transistors is a junction-less transistor.

## Description

This application claims priority of U.S. Patent Application Serial Nos. 12/792,673 (now U.S. Patent 7,964,916), 12/797,493 (now U.S. Patent 8,115,511), 12/847,911(now U.S. Patent 7,960,242), 12/849,272 (now U.S. Patent 7,986,042), 12/859,665 (now U.S. Patent 8,405,420), 12/903,862 (now U.S. Patent Application Publication No. 2012/0091474), 12/900,379 (now U.S. Patent 8,395,191), 12/901,890 (now U.S. Patent 8,026,521), 12/949,617 (now U.S. Patent 8,754,533), 12/970,602 (now U.S. Patent 9,711,407), 12,904,119 (now U.S. Patent 8,476,145), 12/951,913(now U.S. Patent 8,536,023), 12/894,252 (now U.S. Patent 8,258,810), 12/904,108 (now U.S. Patent 8,362,800), 12/941,073 (now U.S. Patent 8,427,200), 12/941,074 (now U.S. Patent 9,577,642), 12/941,075 (now U.S. Patent 8,373,439), 12/951,924 (now U.S. Patent 8,492,886), 13/041,405 (now U.S. Patent 8,901,613), 13/041,406 (now U.S. Patent 9,509,313), and 13/016,313 (now U.S. Patent 8,362,482), the contents of which are incorporated by reference.

### BACKGROUND OF THE INVENTION

### Field of the Invention

The invention relates to the general field of Integrated Circuit (IC) devices and fabrication methods, and more particularly to multilayer or Three Dimensional Integrated Circuit (3D-IC) devices

### 2. Discussion of Background Art

3D stacking of semiconductor chips may be one avenue to tackle issues with wires. By arranging transistors in 3 dimensions instead of 2 dimensions (as was the case in the 1990s), one can place transistors in ICs closer to each other. This reduces wire lengths and keeps wiring delay low.

There are many techniques to construct 3D stacked integrated circuits or chips including:

Through-silicon via (TSV) technology: Multiple layers of transistors (with or without wiring levels) can be constructed separately. Following this, they can be bonded to each other and connected to each other with through-silicon vias (TSVs).

Monolithic 3D technology: With this approach, multiple layers of transistors and wires can be monolithically constructed. Some monolithic 3D approaches are described in US Patent Application 12/900379, now U.S. Patent 8,395,191, and US Patent Application 12/904119, now U.S. Patent 8,476,145.

### SUMMARY

In one aspect, a method for fabrication of a 3D semiconductor device, the method comprising: providing a substrate comprising a single crystal layer; forming a plurality of first transistors in and on said single crystal layer; then forming at least one metal layer, said at least one metal layer comprising connections between said first transistors, wherein a portion of said at least one metal layer comprising connections between said first transistors forms peripheral circuits; then forming a stack of at least six layers, wherein said stack of at least six layers comprises odd numbered layers and even numbered layers, wherein said odd numbered layers comprise a first material and said even numbered layers comprise a second material, wherein said first material is of a different composition than said second material, and wherein said forming a stack is performed as part of forming a multilevel memory structure; and then processing said stack of at least six layers forming at least three layers of memory cells, wherein each of said memory cells comprise at least one of a plurality of second transistors, and wherein said at least three layers of memory cells are controlled by said periphery circuits.

In another aspect, a 3D semiconductor device, the device comprising: a plurality of first transistors, overlaid by a plurality of second memory cells, overlaid by a plurality of third memory cells, overlaid by a plurality of fourth memory cells, wherein said second memory cells, said third memory cells and said fourth memory cells are self-aligned, having been processed following the same lithography step, and wherein a periphery circuit comprises at least one of said first transistors and said periphery circuit controls at least one of said second memory cells, at least one of said third memory cells and at least one of said fourth memory cells, and wherein at least one of said second memory cells comprises second transistors, at least one of said second transistors is a junction-less transistor.

In another aspect, a mobile system comprising a semiconductor device, the device comprising: a plurality of first transistors, overlaid by a plurality of second memory cells, overlaid by a plurality of third memory cells, overlaid by a plurality of fourth memory cells, wherein said second memory cells, said third memory cells and said fourth memory cells are self-aligned, having been processed following the same lithography step, and wherein at least one of said first transistors is part of a periphery circuit controlling at least one of said second memory cells, at least one of said third memory cells and at least one of said fourth memory cells, and wherein at least one of said second memory cells comprises second transistors, at least one of said second transistors is a junction-less transistor.

### BRIEF DESCRIPTION OF THE DRAWINGS

Various embodiments of the invention will be understood and appreciated more fully from the following detailed description, taken in conjunction with the drawings in which:
Figs. 1A-1D are exemplary drawing illustrations of a layer transfer flow using ion-cut in which a top layer of doped Si may be layer transferred atop a generic bottom layer;
Fig. 2 is an exemplary drawing illustration of a possible structure produced from the process of Figs. 1A-1D;
Figs. 3A-3I are exemplary drawing illustrations of a zero-mask per layer 3D resistive memory with a junction-less transistor process flow and structure;
Figs. 4A-4C are exemplary drawing illustrations of a zero-mask per layer 3D charge-trap memory process flow and structure;
Figs. 5A-5B are exemplary drawing illustrations of periphery below and on top of memory layers;
Figs. 5C is exemplary drawing illustration of a periphery on top of memory layers structure;
Figs. 6A-6G are exemplary drawing illustrations of the formation of a floating gate memory transistor with process flow and structure;
Figs. 6H-6M are exemplary drawing illustrations of a two-mask per layer 3D resistive memory process flow and structure;
Figs. 7A-7H are exemplary drawing illustrations of the formation of a floating gate memory transistor with process flow and structure;
Fig. 8A is an exemplary drawing illustration of a programmable device layers structure;
Figs. 8B-8I are exemplary drawing illustrations of the preprocessed wafers and layers and generalized layer transfer;
Fig. 9 is an exemplary drawing illustration of a transferred layer on top of a main wafer, donor layer/wafer and receptor wafer in an alignment scheme;
Fig. 10A is an exemplary drawing illustration of a metallization scheme for 2D integrated circuits and chips;
Fig. 10B is an exemplary drawing illustration of a metallization scheme for monolithic 3D integrated circuits and chips;
Fig. 11A is an exemplary drawing illustration of an 8x12 array of the repeatable structure of FIG. 92C of incorporated reference PCT/2011/042071;
Fig. 11B is an exemplary drawing illustration of a reticle of the repeatable structure of FIG. 92C of incorporated reference PCT/2011/042071;
Fig. 11C is an exemplary drawing illustration of the application of a dicing line mask to a continuous array of the structure of Fig. 11A;
Fig. 11D is an exemplary drawing illustration of a continuous array reticle of RAM tiles;
Fig. 11E is an exemplary drawing illustration of continuous array reticle of DRAM tiles;
Fig. 11F is an exemplary drawing illustration of a six transistor memory cell suitable for use in a continuous array memory;
Fig. 11G is an exemplary drawing illustration of a continuous array of the memory cells of FIG. 11F with an etching pattern defining a 4x4 array;
Fig. 11H is an exemplary drawing illustration of a word decoder on another layer suitable for use with the defined array of Fig. 11G;
Fig. 11I is an exemplary drawing illustration of a column decoder and sense amplifier on another layer suitable for use with the defined array of Fig. 11G;
Figs. 12A-12E are exemplary drawing illustrations of a process flow for constructing 3D stacked logic chips using junction-less transistors as switches;
Figs. 13A-13D are exemplary drawing illustrations of different types of junction-less transistors (JLT) that could be utilized for 3D stacking applications;
Figs. 13E-13I are exemplary drawing illustrations of a process flow for manufacturing junction-less transistors with reduced lithography steps;
Figs. 13J-13M are exemplary drawing illustrations of formation of top planar transistors;
Figs. 14A-14D are exemplary drawing illustrations of an advanced TSV flow;
Figs. 15A-15C are exemplary drawing illustrations of a portion the formation of a junction-less transistor;
Figs. 16A-16E are exemplary drawing illustrations of the formation of a vertically oriented junction-less transistor with process flow and structure;
Figs. 17A-17E are exemplary drawing illustrations of a process flow for manufacturing recessed channel junction-less transistors and its structure;
Figs. 18A-18B are exemplary drawing illustrations of a 3D NAND8 cell;
Figs. 18C-18D are exemplary drawing illustrations of a 3D NOR8 cell;
Fig. 19A is an exemplary drawing illustration of a cross sections of a 3D inverter cell;
Fig. 19B is an exemplary drawing illustration of a 3D CMOS Transmission cell;
Fig. 20A is an exemplary drawing illustration of underlying back bias circuits;
Fig. 20B is an exemplary drawing illustration of underlying power control circuits;
Fig. 21A is an exemplary drawing illustration of an underlying I/O;
Fig. 21B is an exemplary drawing illustration of side "cut";
Fig. 21C is an exemplary drawing illustration of a 3D IC system;
Fig. 21D is an exemplary drawing illustration of a 3D IC processor and DRAM system;
Fig. 21E is an exemplary drawing illustration of a 3D IC processor and DRAM system;
Fig. 21F is an exemplary drawing illustration of a custom SOI wafer used to build through-silicon connections;
Fig. 21G is an exemplary drawing illustration of a prior art method to make through-silicon vias;
Fig. 21H is an exemplary drawing illustration of a process flow for making custom SOI wafers;
Fig. 21I is an exemplary drawing illustration of a processor-DRAM stack;
Fig. 21J is an exemplary drawing illustration of a process flow for making custom SOI wafers;
Fig. 22A is an exemplary drawing illustration of the power distribution network of a 3D integrated circuit; and
Fig. 22B is an exemplary drawing illustration of the thermal contact concept.

### DETAILED DESCRIPTION

Embodiments of the invention are now described with reference to the figures, it being appreciated that the figures illustrate the subject matter not to scale or to measure. Many figures describe process flows for building devices. These process flows, which are essentially a sequence of steps for building a device, have many structures, numerals and labels that are common between two or more adjacent steps. In such cases, some labels, numerals and structures used for a certain step's figure may have been described in previous steps' figures.

Embodiments of the invention are now described with reference to the drawing figures. Persons of ordinary skill in the art will appreciate that the description and figures illustrate rather than limit the invention and that in general the figures are not drawn to scale for clarity of presentation. Such skilled persons will also realize that many more embodiments are possible by applying the inventive principles contained herein and that such embodiments fall within the scope of the invention which is not to be limited except by the spirit of the appended claims.

This section of the document describes a technology to construct single-crystal silicon transistors atop wiring layers with less than 400°C processing temperatures. This allows construction of 3D stacked semiconductor chips with a high density of connections between different layers, because the top-level transistors are formed well-aligned to bottom-level wiring and transistor layers. Since the top-level transistor layers are very thin (preferably less than about 200nm), alignment can be done through these thin silicon and oxide layers to features in the bottom-level.

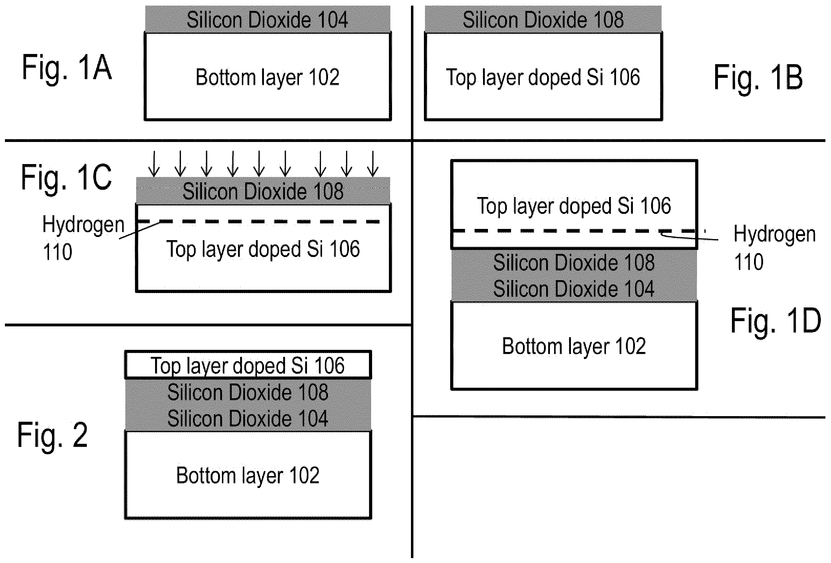

Figs. 1A-1D illustrates an ion-cut flow for layer transferring a single crystal silicon layer atop any generic bottom layer 102. The bottom layer 102 can be a single crystal silicon layer. Alternatively, it can be a wafer having transistors with wiring layers above it. This process of ion-cut based layer transfer may include several steps, as described in the following sequence:
Step (A): A silicon dioxide layer 104 may be deposited above the generic bottom layer 102. Fig. 1A illustrates the structure after Step (A) is completed.
Step (B): The top layer of doped or undoped silicon 106 to be transferred atop the bottom layer may be processed and an oxide layer 108 may be deposited or grown above it. Fig. 1B illustrates the structure after Step (B) is completed.
Step (C): Hydrogen may be implanted into the top layer silicon 106 with the peak at a certain depth to create the hydrogen plane 110. Alternatively, another atomic species such as helium or boron can be implanted or co-implanted. Fig. 1C illustrates the structure after Step (C) is completed.
Step (D): The top layer wafer shown after Step (C) may be flipped and bonded atop the bottom layer wafer using oxide-to-oxide bonding. Fig. 1D illustrates the structure after Step (D) is completed.
Step (E): A cleave operation may be performed at the hydrogen plane 110 using an anneal.

Alternatively, a sideways mechanical force may be used. Further details of this cleave process are described in "Frontiers of silicon-on-insulator," J. Appl. Phys. 93, 4955-4978 (1003) by G. K. Celler and S. Cristoloveanu ("Celler") and "Mechanically induced Si layer transfer in hydrogen-implanted Si wafers," Appl. Phys. Lett., vol. 76, pp. 1370-1372, 1000 by K. Henttinen, I. Suni, and S. S. Lau ("Hentinnen"). Following this, a Chemical-Mechanical-Polish (CMP) may be done. Fig. 2 illustrates the structure after Step (E) is completed.

One method to solve the issue of high-temperature source-drain *junction* processing may be to make transistors without junctions i.e. Junction-Less Transistors (JLTs). An embodiment of this invention uses JLTs as a building block for 3D stacked semiconductor circuits and chips.

Further details of the JLT can be found in "Junctionless multigate field-effect transistor," Appl. Phys. Lett., vol. 94, pp. 053511 2009 by C.-W. Lee, A. Afzalian , N. Dehdashti Akhavan , R. Yan , I. Ferain and J. P. Colinge ("C-W. Lee"). Contents of this publication are incorporated herein by reference.

Many of the types of embodiments of this invention described herein utilize single crystal silicon or mono-crystalline silicon transistors. These terms may be used interchangeably. Thicknesses of layer transferred regions of silicon are <2µm, and many times can be <1µm or <0.4µm or even <0.2µm. Interconnect (wiring) layers are preferably constructed substantially of copper or aluminum or some other high conductivity material.

While ion-cut has been described in previous sections as the method for layer transfer, several other procedures exist that fulfill the same objective. These include:
- Lift-off or laser lift-off: Background information for this technology is given in "Epitaxial lift-off and its applications", 1993 Semicond. Sci. Technol. 8 1124 by P Demeester et al. ("Demesster").
- Porous-Si approaches such as ELTRAN: Background information for this technology is given in "Eltran, Novel SOI Wafer Technology", JSAP International, Number 4, July 2001 by T. Yonehara and K. Sakaguchi ("Yonehara") and also in "Frontiers of silicon-on-insulator," J. Appl. Phys. 93, 4955-4978, 2003 by G. K. Celler and S. Cristoloveanu ("Celler").
- Time-controlled etch-back to thin an initial substrate, Polishing, Etch-stop layer controlled etch-back to thin an initial substrate: Background information on these technologies is given in Celler and in US

Patent Number 6806171. - Rubber-stamp based layer transfer: Background information on this technology is given in "Solar cells sliced and diced", 19th May 2010, Nature News.

The above publications giving background information on various layer transfer procedures are incorporated herein by reference. It is obvious to one skilled in the art that one can form 3D integrated circuits and chips as described in this document with the layer transfer schemes described in these publications above.

While many of today's memory technologies rely on charge storage, several companies are developing non-volatile memory technologies based on resistance of a material changing. Examples of these resistance-based memories include phase change memory, Metal Oxide memory, resistive RAM (RRAM), memristors, solid-electrolyte memory, ferroelectric RAM, conductive bridge RAM, and MRAM. Background information on these resistive-memory types is given in "Overview of candidate device technologies for storage-class memory," IBM Journal of Research and Development , vol.52, no.4.5, pp.449-464, July 2008 by Burr, G. W.; Kurdi, B. N.; Scott, J. C.; Lam, C. H.; Gopalakrishnan, K.; Shenoy, R. S.

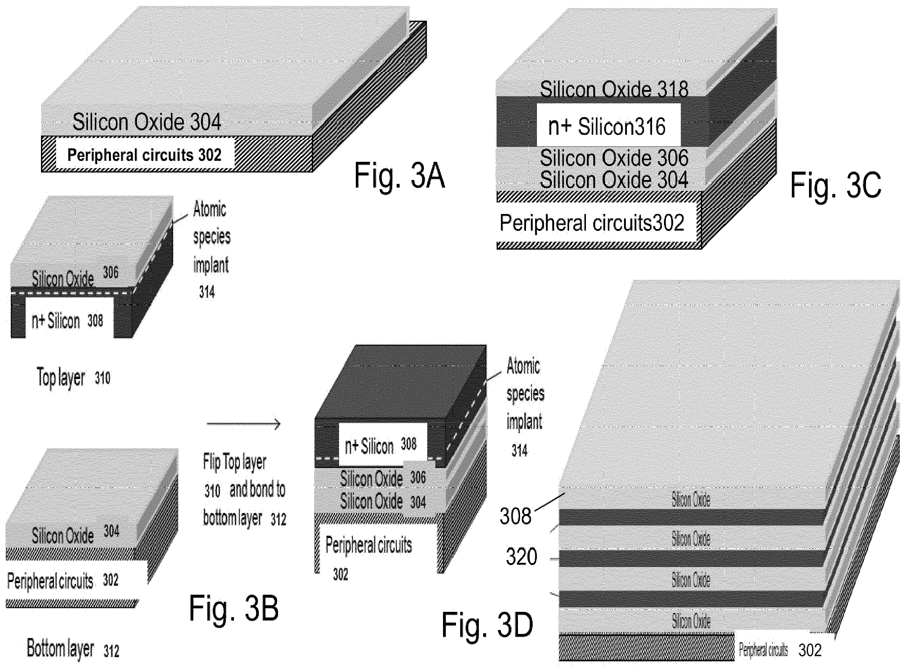

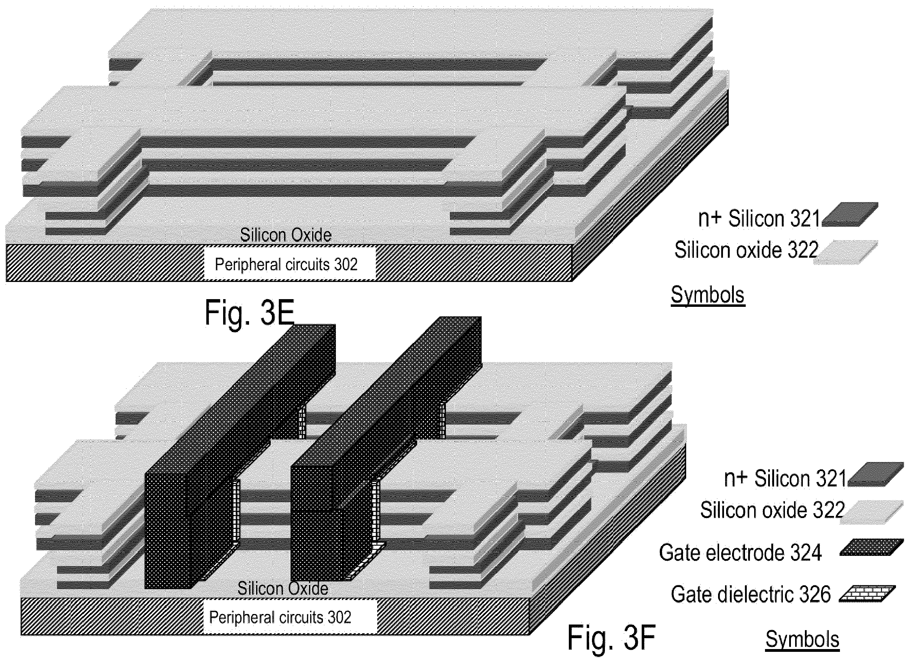

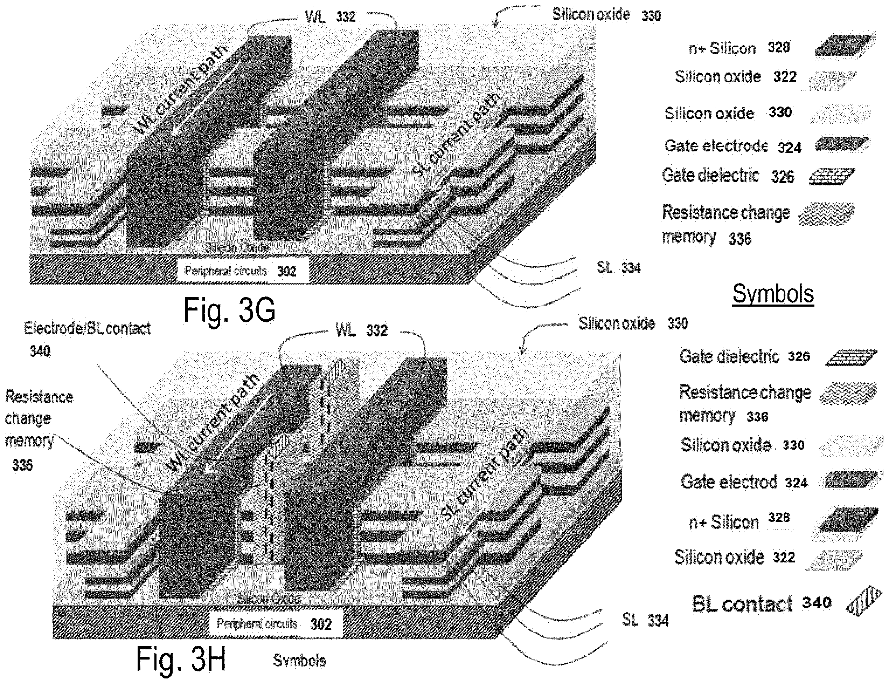

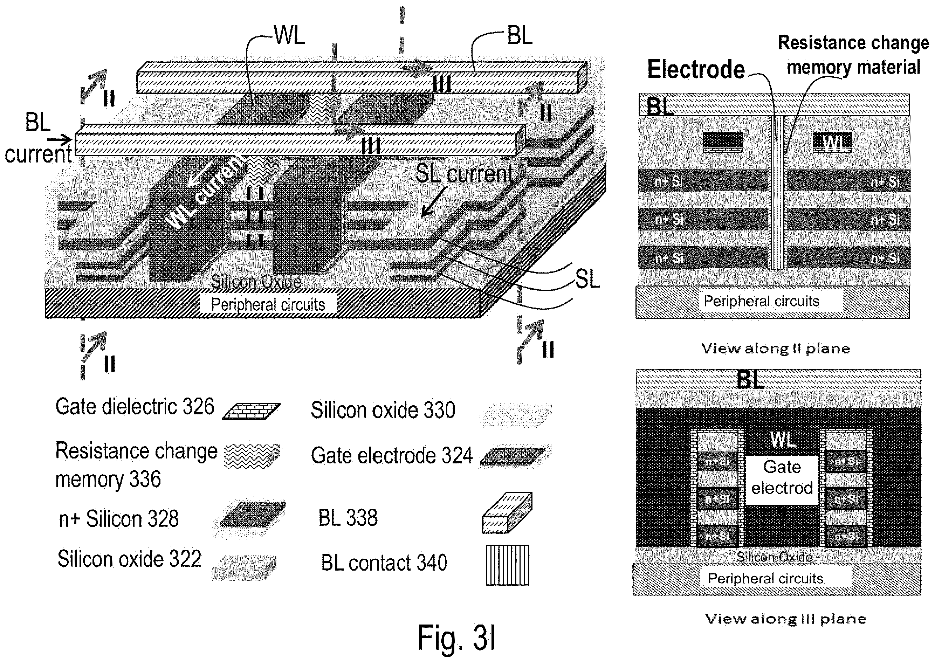

Figs. 3A-3I describe a novel memory architecture for resistance-based memories, and a procedure for its construction. The memory architecture utilizes junction-less transistors and has a resistance-based memory element in series with a transistor selector. No mask may be utilized on a "per-memory-layer" basis for the monolithic 3D resistance change memory (or resistive memory) concept shown in Figs. 3A-3I, and all other masks are shared between different layers. The process flow may include several steps that occur in the following sequence.
Step (A): Peripheral circuits 302 are first constructed and above this oxide layer 304 may be deposited. Fig. 3A shows a drawing illustration after Step (A).
Step (B): Fig. 3B illustrates the structure after Step (B). N+ Silicon wafer 308 has an oxide layer 306 grown or deposited above it. A doped and activated layer may be formed in or on N+ silicon wafer 308 by processes such as, for example, implant and RTA or furnace activation, or epitaxial deposition and activation. Following this, hydrogen may be implanted into the n+ Silicon wafer at a certain depth indicated by 314. Alternatively, some other atomic species such as Helium could be (co-)implanted. This hydrogen implanted n+ Silicon wafer 308 forms the top layer 310. The bottom layer 312 may include the peripheral circuits 302 with oxide layer 304. The top layer 310 may be flipped and bonded to the bottom layer 312 using oxide-to-oxide bonding.
Step (C): Fig. 3C illustrates the structure after Step (C). The stack of top and bottom wafers after Step (B) may be cleaved at the hydrogen plane 314 using either a anneal or a sideways mechanical force or other means. A CMP process may be then conducted. A layer of silicon oxide 318 may be then deposited atop the n+ Silicon layer 316. At the end of this step, a single-crystal n+ Si layer 316 exists atop the peripheral circuits, and this has been achieved using layer transfer techniques.
Step (D): Fig. 3D illustrates the structure after Step (D). Using methods similar to Step (B) and (C), multiple n+ silicon layers 320 are formed with silicon oxide layers in between.
Step (E): Fig. 3E illustrates the structure after Step (E). Lithography and etch processes may then be utilized to make a structure as shown in the figure, including n+ silicon layer regions 321 and silicon oxide layer regions 322.
Step (F): Fig. 3F illustrates the structure after Step (F). Gate dielectric 326 and gate electrode 324 are then deposited following which a CMP may be performed to planarize the gate electrode 324 regions. Lithography and etch are utilized to define gate regions.
Step (G): Fig. 3G illustrates the structure after Step (G). A silicon oxide layer 330 may be then deposited and planarized. The silicon oxide layer is shown transparent in the figure for clarity, along with word-line (WL) 332 and source-line (SL) 334 regions.
Step (H): Fig. 3H illustrates the structure after Step (H). Vias are etched through multiple layers of silicon and silicon dioxide as shown in the figure. A resistance change memory material 336 may be then deposited (preferably with atomic layer deposition (ALD)). Examples of such a material include hafnium oxide, well known to change resistance by applying voltage. An electrode for the resistance change memory element may be then deposited (preferably using ALD) and is shown as electrode/BL contact 340. A CMP process may be then conducted to planarize the surface. It can be observed that multiple resistance change memory elements in series with junction-less transistors are created after this step.
Step (I): Fig. 3I illustrates the structure after Step (I). BLs 338 are then constructed. Contacts are made to BLs, WLs and SLs of the memory array at its edges. SL contacts can be made into stair-like structures using techniques described in "Bit Cost Scalable Technology with Punch and Plug Process for Ultra High Density Flash Memory," VLSI Technology, 2007 IEEE Symposium on, vol., no., pp.14-15, 12-14 June 2007 by Tanaka, H.; Kido, M.; Yahashi, K.; Oomura, M.; et al., following which contacts can be constructed to them. Formation of stair-like structures for SLs could be achieved in steps prior to Step (I) as well.

Fig. 3J shows cross-sectional views of the array for clarity.
A 3D resistance change memory has thus been constructed, with (1) horizontally-oriented transistors - i.e. current flowing in substantially the horizontal direction in transistor channels, (2) some of the memory cell control lines, e.g., source-lines SL, constructed of heavily doped silicon and embedded in the memory cell layer, (3) side gates that are simultaneously deposited over multiple memory layers for transistors, and (4) mono-crystalline (or single-crystal) silicon layers obtained by layer transfer techniques such as ion-cut.

While explanations have been given for formation of monolithic 3D resistive memories with ion-cut in this section, it is clear to one skilled in the art that alternative implementations are possible. BL and SL nomenclature has been used for two terminals of the 3D resistive memory array, and this nomenclature can be interchanged. Moreover, selective epi technology or laser recrystallization technology could be utilized for implementing structures shown in Fig. 3A-3I. Various other types of layer transfer schemes that have been described herein can be utilized for construction of various 3D resistive memory structures. One could also use buried wiring, i.e. where wiring for memory arrays may be below the memory layers but above the periphery. Other variations of the monolithic 3D resistive memory concepts are possible.

As illustrated in Figure 3I, BL metal lines 338 may be formed and connected to the associated BL contacts 340. Contacts and associated metal interconnect lines (not shown) may be formed for the WL and SL at the memory array edges. SL contacts can be made into stair-like structures using techniques described in "Bit Cost Scalable Technology with Punch and Plug Process for Ultra High Density Flash Memory," VLSI Technology, 2007 IEEE Symposium on, vol., no., pp.14-15, 12-14 June 2007 by Tanaka, H.; Kido, M.; Yahashi, K.; Oomura, M.; et al.

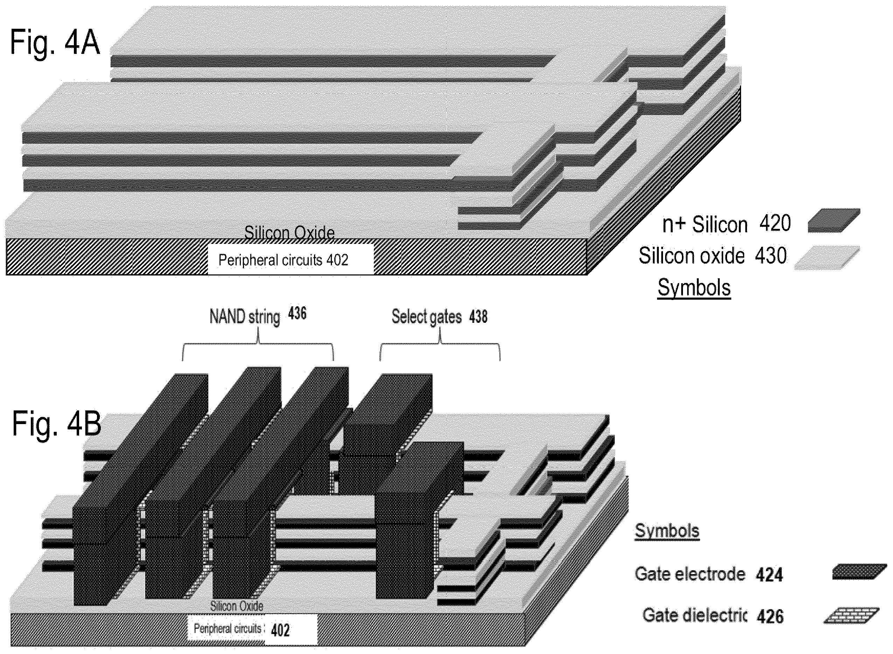

While resistive memories described previously form a class of non-volatile memory, others classes of non-volatile memory exist. NAND flash memory forms one of the most common non-volatile memory types. It can be constructed of two main types of devices: floating-gate devices where charge is stored in a floating gate and charge-trap devices where charge is stored in a charge-trap layer such as Silicon Nitride. Background information on charge-trap memory can be found in *"*Integrated Interconnect Technologies for 3D Nanoelectronic Systems", Artech House, 2009 by Bakir and Meindl ("Bakir") and "A Highly Scalable 8-Layer 3D Vertical-Gate (VG) TFT NAND Flash Using Junction-Free Buried Channel BE-SONOS Device," Symposium on VLSI Technology, 2010 by Hang-Ting Lue, *et al.* The architectures shown in Figs. 4A-4C are relevant for any type of charge-trap memory.

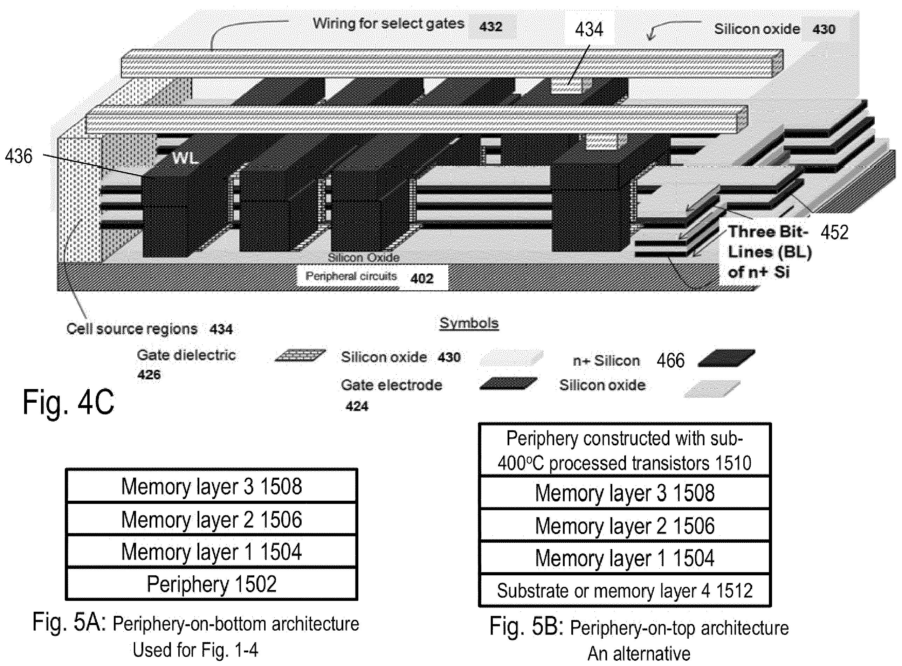

Fig. 4A-4C describes a memory architecture for single-crystal 3D charge-trap memories, and a procedure for its construction. It utilizes junction-less transistors. No mask may be utilized on a "per-memory-layer" basis for the monolithic 3D charge-trap memory concept shown in Fig. 4A-C, and all other masks are shared between different layers. The process flow may include several steps as described in the following sequence. Steps (A) to Step (D) could be done as presented in respect to Fig. 3A to 3D.
Step (E): Fig. 4A illustrates the structure after Step (E). Lithography and etch processes are then utilized to make a structure as shown in the figure.
Step (F): Fig. 4B illustrates the structure after Step (F). Gate dielectric 426 and gate electrode 424 are then deposited following which a CMP may be done to planarize the gate electrode 424 regions. Lithography and etch are utilized to define gate regions. Gates of the NAND string 436 as well gates of select gates of the NAND string 438 are defined.
Step (G): Fig. 4C illustrates the structure after Step (G). A silicon oxide layer 430 may be then deposited and planarized. It is shown transparent in the figure for clarity. Word-lines, bit-lines and source-lines are defined as shown in the figure. Contacts are formed to various regions/wires at the edges of the array as well. SL contacts can be made into stair-like structures using techniques described in "Bit Cost Scalable Technology with Punch and Plug Process for Ultra High Density Flash Memory," VLSI Technology, 2007 IEEE Symposium on, vol., no., pp.14-15, 12-14 June 2007 by Tanaka, H.; Kido, M.; Yahashi, K.; Oomura, M.; et al., following which contacts can be constructed to them. Formation of stair-like structures for SLs could be performed in steps prior to Step (G) as well.
A 3D charge-trap memory has thus been constructed, with (1) horizontally-oriented transistors - i.e. current flowing in substantially the horizontal direction in transistor channels, (2) some of the memory cell control lines - e.g., bit lines BL, constructed of heavily doped silicon and embedded in the memory cell layer, (3) side gates simultaneously deposited over multiple memory layers for transistors, and (4) mono-crystalline (or single-crystal) silicon layers obtained by layer transfer techniques such as ion-cut. This use of single-crystal silicon obtained with ion-cut is a key differentiator from past work on 3D charge-trap memories such as "A Highly Scalable 8-Layer 3D Vertical-Gate (VG) TFT NAND Flash Using Junction-Free Buried Channel BE-SONOS Device," Symposium on VLSI Technology, 2010 by Hang-Ting Lue, et al. that used polysilicon.

While Fig. 4A-4Cgive example of how single-crystal silicon layers with ion-cut can be used to produce 3D charge-trap memories, the ion-cut technique for 3D charge-trap memory may be fairly general. It could be utilized to produce any horizontally-oriented 3D mono-crystalline silicon charge-trap memory. Fig. 4A-4C further illustrates how general the process can be. One or more doped silicon layers 420, including oxide layer 430, can be layer transferred atop any peripheral circuit layer 402 using procedures shown in Fig. 1-Fig. 2. These are indicated in Fig. 3A, Fig. 3B and Fig. 3C. Following this, different procedures can be utilized to form different types of 3D charge-trap memories. For example, procedures shown in "A Highly Scalable 8-Layer 3D Vertical-Gate (VG) TFT NAND Flash Using Junction-Free Buried Channel BE-SONOS Device," Symposium on VLSI Technology, 2010 by Hang-Ting Lue, *et al.* and "Multi-layered Vertical Gate NAND Flash overcoming stacking limit for terabit density storage", Symposium on VLSI Technology, 2009 by W. Kim, S. Choi, *et al.* can be used to produce the two different types of horizontally oriented single crystal silicon 3D charge trap memory shown in Fig. 4C.

Fig. 5A-B may not be the only option for the architecture, as depicted in, for example, Fig. 1 through Fig. 4. Peripheral transistors within periphery layer 1502 may be constructed below the memory layers, for example, memory layer 1 1504, memory layer 2 1506, and/or memory layer 3 1508. Peripheral transistors within periphery layer 1510 could also be constructed above the memory layers, for example, memory layer 1 504, memory layer 2 1506, and/or memory layer 3 1508, which may be atop substrate or memory layer 4 1512, as shown in Fig. 5B.

### Poly-Silicon-based Implementation of Various Memory Concepts

The monolithic 3D integration concepts described in this patent application can lead to novel embodiments of poly-silicon-based memory architectures as well. Poly silicon based architectures could potentially be cheaper than single crystal silicon based architectures when a large number of memory layers need to be constructed. While the below concepts are explained by using resistive memory architectures as an example, it will be clear to one skilled in the art that similar concepts can be applied to NAND flash memory and DRAM architectures described in this patent application.

Fig. 3A and 3D-3J could be used to shows one such embodiment, where polysilicon junction-less transistors are used to form a 3D memory. The utilized junction-less transistors can have either positive or negative threshold voltages. The process may include the following steps as described in the following sequence:
Step (A): As illustrated in Fig. 3A, peripheral circuits 302 are constructed above which oxide layer 304 is made.
Step (B): As illustrated in Fig. 3D, multiple layers of n+ doped amorphous silicon or polysilicon 320,
are deposited with layers of silicon dioxide 308 in between. The amorphous silicon or polysilicon layers 320 could be deposited using a chemical vapor deposition process, such as Low Pressure Chemical Vapor Deposition (LPCVD) or Plasma Enhanced Chemical Vapor Deposition (PECVD)..
Step (C): A Rapid Thermal Anneal (RTA) could be conducted to crystallize the layers of polysilicon or amorphous silicon deposited in Step (C). Temperatures during this RTA could be as high as 500°C or more, and could even be as high as 800°C. Alternatively, a laser anneal could be conducted, either for all amorphous silicon or polysilicon layers 320 at the same time or layer by layer. The thickness of the oxide layer 304 could be optimized if that process were conducted.
Step (D): As illustrated in Fig. 3H, procedures similar to those described in Fig. 3E-3H are utilized to construct the structure shown. The structure in Fig. 3H has multiple levels of junction-less transistor selectors for resistive memory devices. The resistance change memory is indicated as 336 while its electrode and contact to the BL is indicated as 340. The WL is indicated as 332, while the SL is indicated as 334. Gate dielectric of the junction-less transistor is indicated as 326 while the gate electrode of the junction-less transistor is indicated as 324, this gate electrode also serves as part of the WL 332.
Step (E): As illustrated in Fig. 3J,bit lines (indicated as BL 338) are constructed. Contacts are then made to peripheral circuits and various parts of the memory array as described in embodiments described previously.

Charge trap NAND (Negated AND) memory devices are another form of popular commercial non-volatile memories. Charge trap device store their charge in a charge trap layer, wherein this charge trap layer then influences the channel of a transistor. Background information on charge-trap memory can be found in "Integrated Interconnect Technologies for 3D Nanoelectronic Systems", Artech House, 2009 by Bakir and Meindl (hereinafter Bakir), "A Highly Scalable 8-Layer 3D Vertical-Gate (VG) TFT NAND Flash Using Junction-Free Buried Channel BE-SONOS Device," Symposium on VLSI Technology, 2010 by Hang-Ting Lue, et al. and "Introduction to Flash memory," Proc. IEEE 91, 489-502 (2003) by R. Bez, et al.. Work described in Bakir utilized selective epitaxy, laser recrystallization, or polysilicon to form the transistor channel.

As illustrated in Figs. 4A to 4C, a charge trap based 3D memory with zero additional masking steps per memory layer 3D memory may be constructed that is suitable for 3D IC manufacturing. This 3D memory utilizes NAND strings of charge trap junction-less transistors with junction-less select transistors constructed in mono-crystalline silicon.

As illustrated in Fig. 4C, the entire structure may be covered with a gap fill oxide 430, which may be planarized with chemical mechanical polishing. The oxide 430 is shown transparent in the figure for clarity. Select metal lines 432 may be formed and connected to the associated select gate contacts 434. Contacts and associated metal interconnect lines (not shown) may be formed for the WL and SL at the memory array edges. Word-line regions (WL) 436, gate electrodes 424, and bit-line regions (BL) 452 including indicated N+ silicon regions 466, are shown. Source regions 434 may be formed by trench contact etch and fill to couple to the N+ silicon regions on the source end of the NAND string 436. A thru layer via (not shown) may be formed to electrically couple the BL, SL, and WL metallization to the acceptor substrate peripheral circuitry via an acceptor wafer metal connect pad (not shown).

This flow may enable the formation of a charge trap based 3D memory with zero additional masking steps per memory layer constructed by layer transfers of wafer sized doped layers of mono-crystalline silicon and this 3D memory may be connected to an underlying multi-metal layer semiconductor device.

Persons of ordinary skill in the art will appreciate that the illustrations in Figs. 4A through 4C are exemplary only and are not drawn to scale. Such skilled persons will further appreciate that many variations are possible such as, for example, BL or SL contacts may be constructed in a staircase manner as described previously. Moreover, the stacked memory layer may be connected to a periphery circuit that is above the memory stack. Additionally, each tier of memory could be configured with a slightly different donor wafer N+ layer doping profile. Further, the memory could be organized in a different manner, such as BL and SL interchanged, or where buried wiring for the memory array is below the memory layers but above the periphery. Additional types of 3D charge trap memories may be constructed by layer transfer of mono-crystalline silicon; for example, those found in "A Highly Scalable 8-Layer 3D Vertical-Gate (VG) TFT NAND Flash Using Junction-Free Buried Channel BE-SONOS Device," Symposium on VLSI Technology, 2010 by Hang-Ting Lue, et al., and "Multi-layered Vertical Gate NAND Flash overcoming stacking limit for terabit density storage", Symposium on VLSI Technology, 2009 by W. Kim, S. Choi, et al. Many other modifications within the scope of the invention will suggest themselves to such skilled persons after reading this specification. Thus the invention is to be limited only by the appended claims.

Floating gate (FG) memory devices are another form of popular commercial non-volatile memories. Floating gate devices store their charge in a conductive gate (FG) that is nominally isolated from unintentional electric fields, wherein the charge on the FG then influences the channel of a transistor. Background information on floating gate flash memory can be found in "Introduction to Flash memory", Proc. IEEE 91, 489-502 (2003) by R. Bez, et al. The architectures shown are relevant for any type of floating gate memory.

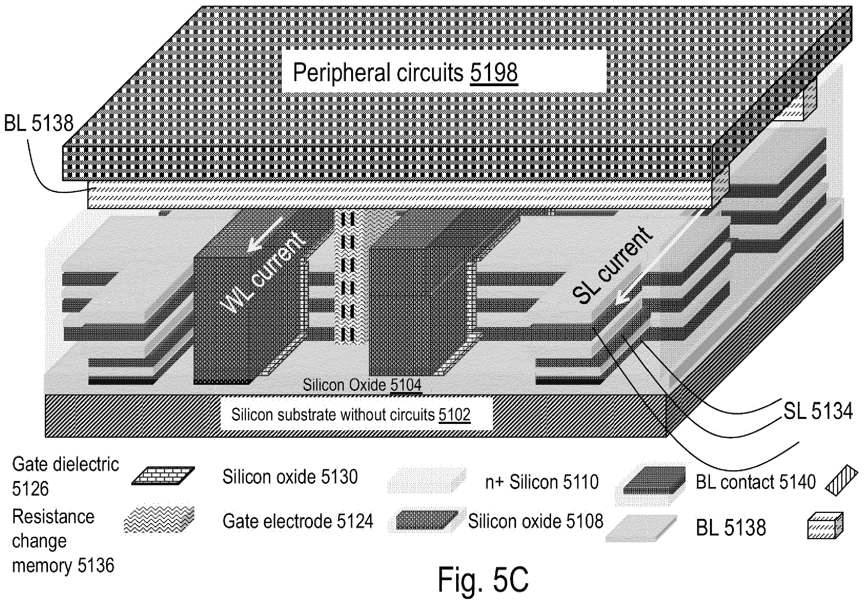

Fig. 5C show another embodiment of the current invention, where polysilicon junction-less transistors are used to form a 3D resistance-based memory. The utilized junction-less transistors can have either positive or negative threshold voltages. The process may include the following steps occurring in sequence:
Step (A): Similar to as illustrated in Fig. 3A, a layer of silicon dioxide 304 is deposited or grown above a silicon substrate without circuits 302.
Step (B): As illustrated in Fig. 3D, multiple layers of n+ doped amorphous silicon or polysilicon 316 are deposited with layers of silicon dioxide 318 in between. The amorphous silicon or polysilicon layers 316 could be deposited using a chemical vapor deposition process, such as LPCVD or PECVD.
Step (C): A Rapid Thermal Anneal (RTA) or standard anneal is conducted to crystallize the layers of polysilicon or amorphous silicon deposited in Step (B). Temperatures during this RTA could be as high as 700°C or more, and could even be as high as 1400°C. Since there are no circuits under these layers of polysilicon, very high temperatures (such as, for example, 1400°C) can be used for the anneal process, leading to very good quality polysilicon with few grain boundaries and very high mobilities approaching those of single crystal silicon. Alternatively, a laser anneal could be conducted, either for all amorphous silicon or polysilicon layers 316 at the same time or layer by layer at different times.
Step (D): Procedures similar to those described are utilized to get the structure shown in Fig. 3H that has multiple levels of junction-less transistor selectors for resistive memory devices. The resistance change memory is indicated as 336, 5136 while its electrode and contact to the BL is indicated as 340, 5138. The WL is indicated as 332, while the SL is indicated as 334, 5134. Gate dielectric of the junction-less transistor is indicated as 326, 5126 while the gate electrode of the junction-less transistor is indicated as 324, 5124, this gate electrode also serves as part of the WL 332.
Step (E): This is similar to as illustrated in Fig. 3J. Bit lines (indicated as BL 338) are constructed. Contacts are then made to peripheral circuits and various parts of the memory array as described in embodiments described previously.
Step (F): Using procedures described in this patent application, peripheral circuits 5198 (with transistors and wires) could be formed well aligned to the multiple memory layers shown in Step (E).
For the periphery, one could use a process flow where replacement gate processing is used, or one could use sub-400°C processed transistors such as junction-less transistors or recessed channel transistors. Alternatively, one could use laser anneals for peripheral transistors' source-drain processing. Connections can then be formed between the multiple memory layers and peripheral circuits. By proper choice of materials for memory layer transistors and memory layer wires (e.g., by using tungsten and other materials that withstand high temperature processing for wiring), even standard transistors processed at high temperatures (>1000°C) for the periphery could be used.

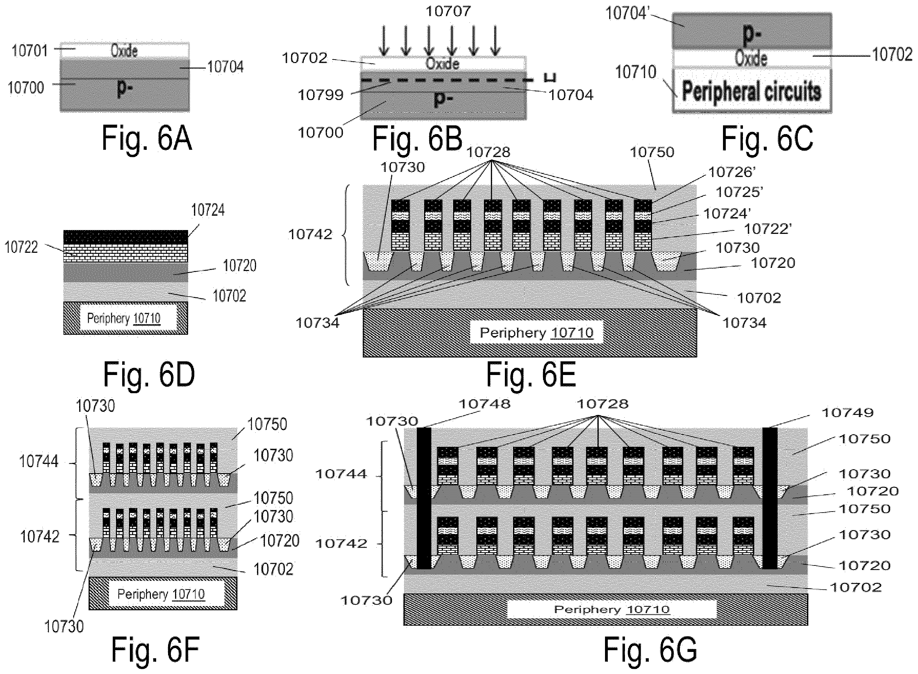

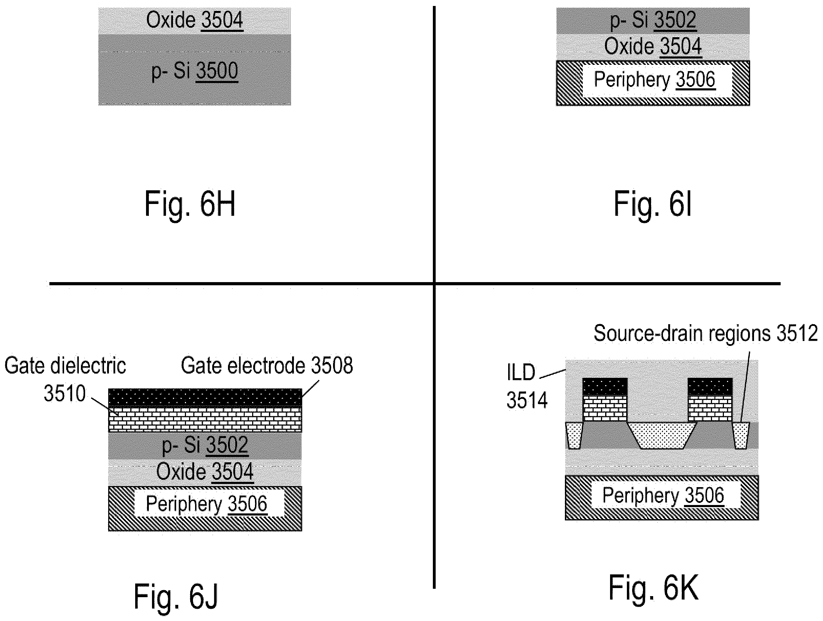

As illustrated in Figs. 6A to 6G, a floating gate based 3D memory with two additional masking steps per memory layer may be constructed that is suitable for 3D IC manufacturing. This 3D memory utilizes NAND strings of floating gate transistors constructed in mono-crystalline silicon.

As illustrated in Fig. 6A, a P- substrate donor wafer 10700 may be processed to include a wafer sized layer of P- doping 10704. The P-doped layer 10704 may have the same or a different dopant concentration than the P- substrate 10700. The P- doped layer 10704 may have a vertical dopant gradient. The P- doped layer 10704 may be formed by ion implantation and thermal anneal. A screen oxide 10701 may be grown before the implant to protect the silicon from implant contamination and to provide an oxide surface for later wafer to wafer bonding.

As illustrated in Fig. 6B, the top surface of donor wafer 10700 may be prepared for oxide wafer bonding with a deposition of an oxide 10702 or by thermal oxidation of the P- doped layer 10704 to form oxide layer 10702, or a re-oxidation of implant screen oxide 10701. A layer transfer demarcation plane 10799 (shown as a dashed line) may be formed in donor wafer 10700 or P- layer 10704 (shown) by hydrogen implantation 10707 or other methods as previously described. Both the donor wafer 10700 and acceptor wafer 10710 may be prepared for wafer bonding as previously described and then bonded, preferably at a low temperature (less than approximately 400°C) to minimize stresses. The portion of the P- layer 10704 and the P- donor wafer substrate 10700 that are above the layer transfer demarcation plane 10799 may be removed by cleaving and polishing, or other processes as previously described, such as ion-cut or other methods.

As illustrated in Fig. 6C, the remaining P- doped layer 10704', and oxide layer 10702 have been layer transferred to acceptor wafer 10710. Acceptor wafer 10710 may include peripheral circuits such that they can withstand an additional rapid-thermal-anneal (RTA) and still remain operational and retain good performance. For this purpose, the peripheral circuits may be formed such that they have been subject to a weak RTA or no RTA for activating dopants. Also, the peripheral circuits may utilize a refractory metal such as, for example, tungsten that can withstand high temperatures greater than approximately 400°C. The top surface of P- doped layer 10704' may be chemically or mechanically polished smooth and flat. Now transistors may be formed and aligned to the acceptor wafer 10710 alignment marks (not shown).

As illustrated in Fig. 6D a partial gate stack may be formed with growth or deposition of a tunnel oxide 10722, such as, for example, thermal oxide, and a FG gate metal material 10724, such as, for example, doped or undoped poly-crystalline silicon. Shallow trench isolation (STI) oxide regions (not shown) may be lithographically defined and plasma/RIE etched to at least the top level of oxide layer 10702, thus removing regions of P- mono-crystalline silicon layer 10704' and forming P- doped regions 10720. A gap-fill oxide may be deposited and CMP'ed flat to form conventional STI oxide regions (not shown).

As illustrated in Fig. 6E, an inter-poly oxide layer 10725, such as silicon oxide and silicon nitride layers (ONO: Oxide-Nitride-Oxide), and a Control Gate (CG) gate metal material 10726, such as doped or undoped poly-crystalline silicon, may be deposited. The gate stacks 10728 may be lithographically defined and plasma/RIE etched, thus removing regions of CG gate metal material 10726, inter-poly oxide layer 10725, FG gate metal material 10724, and tunnel oxide 10722. This removal may result in the gate stacks 10728 including CG gate metal regions 10726', inter-poly oxide regions 10725', FG gate metal regions 10724, and tunnel oxide regions 10722'. Only one gate stack 10728 is annotated with region tie lines for clarity. A self-aligned N+ source and drain implant may be performed to create inter-transistor source and drains 10734 and end of NAND string source and drains 10730. Finally, the entire structure may be covered with a gap fill oxide 10750, which may be planarized with chemical mechanical polishing. The oxide surface may be prepared for oxide to oxide wafer bonding as previously described. This now forms the first tier of memory transistors 10742 including silicon oxide layer 10750, gate stacks 10728, inter-transistor source and drains 10734, end of NAND string source and drains 10730, P- silicon regions 10720, and oxide 10702.

As illustrated in Fig. 6F, the transistor layer formation, bonding to acceptor wafer 10710 oxide 10750, and subsequent transistor formation as described in Figs. 6A to 6D may be repeated to form the second tier 10744 of memory transistors on top of the first tier of memory transistors 10742. After substantially all the memory layers are constructed, a rapid thermal anneal (RTA) may be conducted to activate the dopants in substantially all of the memory layers and in the acceptor substrate 10710 peripheral circuits. Alternatively, optical anneals, such as, for example, a laser based anneal, may be performed.

As illustrated in Fig. 6G, source line (SL) ground contact 10748 and bit line contact 10749 may be lithographically defined, etched with plasma/RIE through oxide 10750, end of NAND string source and drains 10730, and P- regions 10720 of each memory tier, and the associated oxide vertical isolation regions to connect substantially all memory layers vertically. SL ground contact 10748 and bit line contact 10749 may then be processed by a photoresist removal. Metal or heavily doped poly-crystalline silicon may be utilized to fill the contacts and metallization utilized to form BL and SL wiring (not shown). The gate stacks 10728 may be connected with a contact and metallization to form the word-lines (WLs) and WL wiring (not shown). A thru layer via 10760 (not shown) may be formed to electrically couple the BL, SL, and WL metallization to the acceptor substrate 10710 peripheral circuitry via an acceptor wafer metal connect pad 10780 (not shown).

This flow may enable the formation of a floating gate based 3D memory with two additional masking steps per memory layer constructed by layer transfers of wafer sized doped layers of mono-crystalline silicon and this 3D memory may be connected to an underlying multi-metal layer semiconductor device.

Persons of ordinary skill in the art will appreciate that the illustrations in Figs. 6A through 6G are exemplary only and are not drawn to scale. Such skilled persons will further appreciate that many variations are possible such as, for example, BL or SL select transistors may be constructed within the process flow. Moreover, the stacked memory layer may be connected to a periphery circuit that is above the memory stack. Additionally, each tier of memory could be configured with a slightly different donor wafer P- layer doping profile. Further, the memory could be organized in a different manner, such as BL and SL interchanged, or where buried wiring for the memory array is below the memory layers but above the periphery. Many other modifications within the scope of the invention will suggest themselves to such skilled persons after reading this specification. Thus the invention is to be limited only by the appended claims.

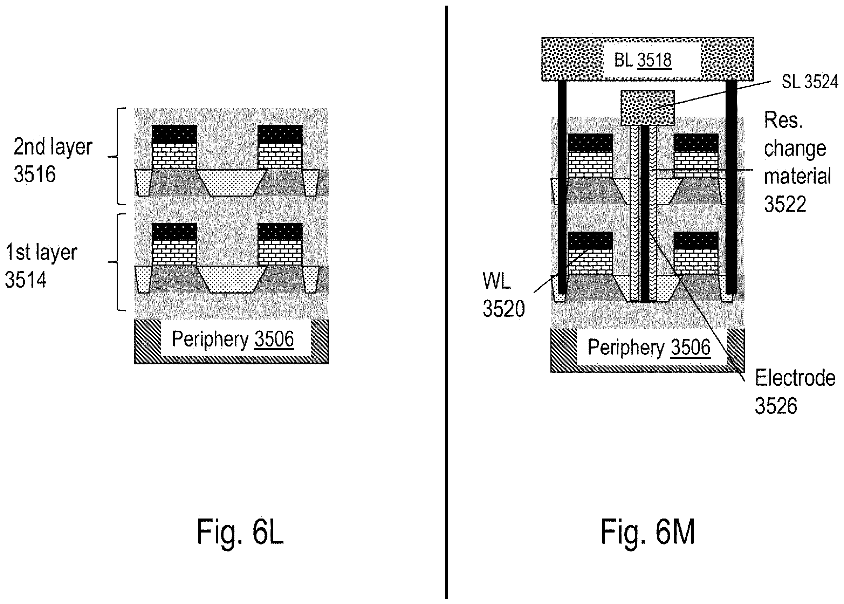

Fig. 6H-6M describes an alternative process flow to construct a horizontally-oriented monolithic 3D resistive memory array. This embodiment has a resistance-based memory element in series with a transistor selector. Two masks are utilized on a "per-memory-layer" basis for the monolithic 3D resistance change memory (or resistive memory) concept shown in Fig. 6H-6M, and all other masks are shared between different layers. The process flow may include several steps as described in the following sequence. Step (A): The process flow starts with a p- silicon wafer 3500 with an oxide coating 3504. A doped and activated layer may be formed in or on p- silicon wafer 3500 by processes such as, for example, implant and RTA or furnace activation, or epitaxial deposition and activation. Fig. 6H illustrates the structure after Step (A). Step (B): Fig. 6J illustrates the structure after Step (B). Using a process flow similar to Fig. 1, portion of p- silicon wafer 3500, p- silicon layer 3502, is transferred atop a layer of peripheral circuits 3506. The peripheral circuits 3506 preferably use tungsten wiring. Step (C): Fig. 6J illustrates the structure after Step (C). Isolation regions for transistors are formed using a shallow-trench-isolation (STI) process. Following this, a gate dielectric 3510 and a gate electrode 3508 are deposited. Step (D): Fig. 6K illustrates the structure after Step (D). The gate is patterned, and source-drain regions 3512 are formed by implantation. An inter-layer dielectric (ILD) 3514 is also formed. Step (E): Fig. 6L illustrates the structure after Step (E). Using steps similar to Step (A) to Step (D), a second layer of transistors 3516 is formed above the first layer of transistors 3514. A RTA or some other type of anneal is performed to activate dopants in the memory layers (and potentially also the peripheral transistors). Step (F): Fig. 6M illustrates the structure after Step (F). Vias are etched through multiple layers of silicon and silicon dioxide as shown in the figure. A resistance change memory material 3522 is then deposited (preferably with atomic layer deposition (ALD)). Examples of such a material include hafnium oxide, which is well known to change resistance by applying voltage. An electrode for the resistance change memory element is then deposited (preferably using ALD) and is shown as electrode 3526. A CMP process is then conducted to planarize the surface. Contacts are made to drain terminals of transistors in different memory layer as well. Note that gates of transistors in each memory layer are connected together perpendicular to the plane of the figure to form word-lines (WL). Wiring for bit-lines (BLs) and source-lines (SLs) is constructed. Contacts are made between BLs, WLs and SLs with the periphery at edges of the memory array. Multiple resistance change memory elements in series with transistors may be created after this step. A 3D resistance change memory has thus been constructed, with (1) horizontally-oriented transistors - i.e. current flowing in substantially the horizontal direction in the transistor channels, and (2) mono-crystalline (or single-crystal) silicon layers obtained by layer transfer techniques such as ion-cut.

While explanations have been given for formation of monolithic 3D resistive memories with ion-cut in this section, it is clear to one skilled in the art that alternative implementations are possible. BL and SL nomenclature has been used for two terminals of the 3D resistive memory array, and this nomenclature can be interchanged. Moreover, selective epi technology or laser recrystallization technology could be utilized for implementing structures shown in Fig. 6H-6M. Various other types of layer transfer schemes can be utilized for construction of various 3D resistive memory structures. One could also use buried wiring, i.e. where wiring for memory arrays is below the memory layers but above the periphery. Other variations of the monolithic 3D resistive memory concepts are possible.

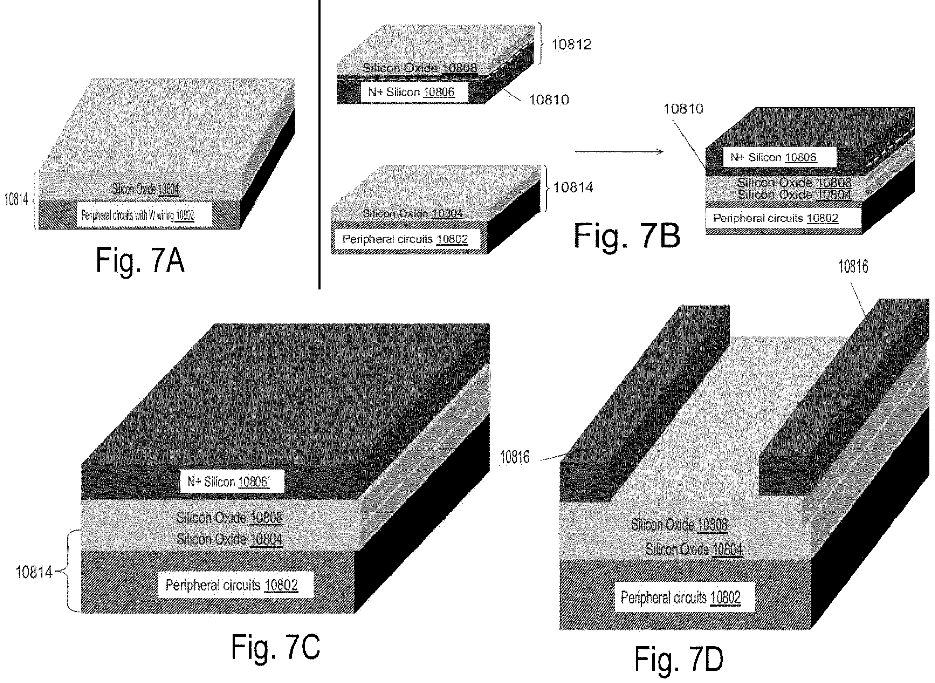

As illustrated in Figs. 7A to 7H, a floating gate based 3D memory with one additional masking step per memory layer 3D memory may be constructed that is suitable for 3D IC manufacturing. This 3D memory utilizes 3D floating gate junction-less transistors constructed in mono-crystalline silicon.

As illustrated in Fig. 7A, a silicon substrate with peripheral circuitry 10802 may be constructed with high temperature (greater than approximately 400°C) resistant wiring, such as, for example, Tungsten. The peripheral circuitry substrate 10802 may include memory control circuits as well as circuitry for other purposes and of various types, such as, for example, analog, digital, RF, or memory. The peripheral circuitry substrate 10802 may include peripheral circuits that can withstand an additional rapid-thermal-anneal (RTA) and still remain operational and retain good performance. For this purpose, the peripheral circuits may be formed such that they have been subject to a weak RTA or no RTA for activating dopants. The top surface of the peripheral circuitry substrate 10802 may be prepared for oxide wafer bonding with a deposition of a silicon oxide 10804, thus forming acceptor wafer 10814.

As illustrated in Fig. 7B, a mono-crystalline N+ doped silicon donor wafer 10812 may be processed to include a wafer sized layer of N+ doping (not shown) which may have a different dopant concentration than the N+ substrate 10806. The N+ doping layer may be formed by ion implantation and thermal anneal. A screen oxide 10808 may be grown or deposited prior to the implant to protect the silicon from implant contamination and to provide an oxide surface for later wafer to wafer bonding. A layer transfer demarcation plane 10810 (shown as a dashed line) may be formed in donor wafer 10812 within the N+ substrate 10806 or the N+ doping layer (not shown) by hydrogen implantation or other methods as previously described. Both the donor wafer 10812 and acceptor wafer 10814 may be prepared for wafer bonding as previously described and then bonded at the surfaces of oxide layer 10804 and oxide layer 10808, at a low temperature (e.g., less than approximately 400°C preferred for lowest stresses), or a moderate temperature (e.g., less than approximately 900°C).

As illustrated in Fig. 7C, the portion of the N+ layer (not shown) and the N+ wafer substrate 10806 that are above the layer transfer demarcation plane 10810 may be removed by cleaving and polishing, or other processes as previously described, such as ion-cut or other methods, thus forming the remaining mono-crystalline silicon N+ layer 10806'. Remaining N+ layer 10806' and oxide layer 10808 have been layer transferred to acceptor wafer 10814. The top surface of N+ layer 10806' may be chemically or mechanically polished smooth and flat. Now transistors or portions of transistors may be formed and aligned to the acceptor wafer 10814 alignment marks (not shown).

**As** illustrated in Fig. 7D N+ regions 10816 may be lithographically defined and then etched with plasma/RIE, thus removing regions of N+ layer 10806' and stopping on or partially within oxide layer 10808.

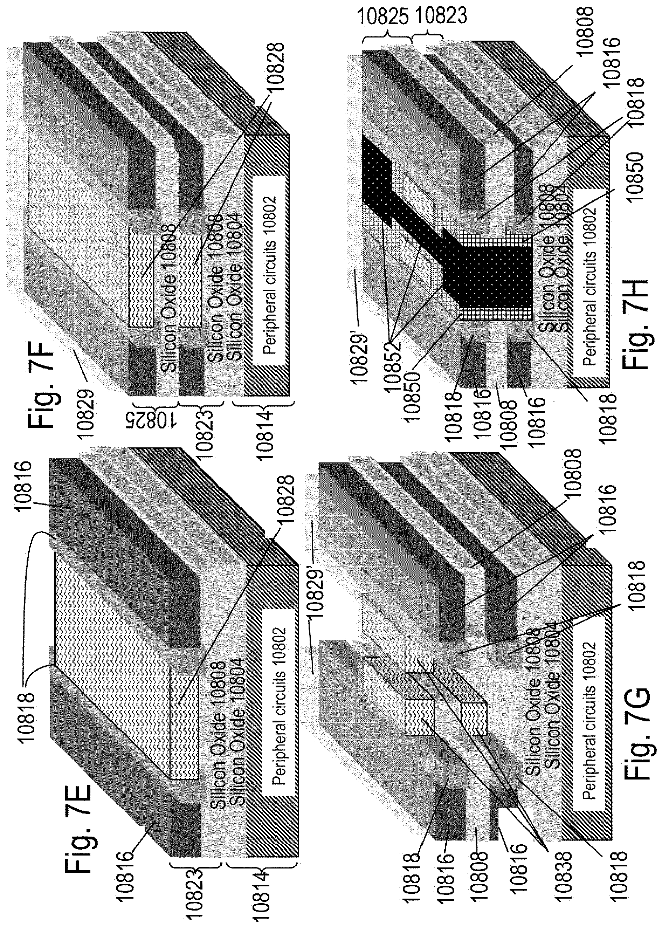

**As** illustrated in Fig. 7E, a tunneling dielectric 10818 may be grown or deposited, such as thermal silicon oxide, and a floating gate (FG) material 10828, such as doped or undoped poly-crystalline silicon, may be deposited. The structure may be planarized by chemical mechanical polishing to approximately the level of the N+ regions 10816. The surface may be prepared for oxide to oxide wafer bonding as previously described, such as a deposition of a thin oxide. This now forms the first memory layer 10823 including future FG regions 10828, tunneling dielectric 10818, N+ regions 10816 and oxide 10808.

**As** illustrated in Fig. 7F, the N+ layer formation, bonding to an acceptor wafer, and subsequent memory layer formation as described in Figs. 7A to 7E may be repeated to form the second layer 10825 of memory on top of the first memory layer 10823. A layer of oxide 10829 may then be deposited.

As illustrated in Fig. 7G, FG regions 10838 may be lithographically defined and then etched along with plasma/RIE removing portions of oxide layer 10829, future FG regions 10828 and oxide layer 10808 on the second layer of memory 10825 and future FG regions 10828 on the first layer of memory 10823, thus stopping on or partially within oxide layer 10808 of the first memory layer 10823.

**As** illustrated in Fig. 7H, an inter-poly oxide layer 10850, such as, for example, silicon oxide and silicon nitride layers (ONO: Oxide-Nitride-Oxide), and a Control Gate (CG) gate material 10852, such as, for example, doped or undoped poly-crystalline silicon, may be deposited. The surface may be planarized by chemical mechanical polishing leaving a thinned oxide layer 10829'. As shown in the illustration, this results in the formation of 4 horizontally oriented floating gate memory bit cells with N+ junction-less transistors. Contacts and metal wiring to form well-know memory access/decoding schemes may be processed and a thru layer via (TLV) may be formed to electrically couple the memory access decoding to the acceptor substrate peripheral circuitry via an acceptor wafer metal connect pad.

This flow may enable the formation of a floating gate based 3D memory with one additional masking step per memory layer constructed by layer transfers of wafer sized doped layers of mono-crystalline silicon and this 3D memory may be connected to an underlying multi-metal layer semiconductor device.

Persons of ordinary skill in the art will appreciate that the illustrations in Figs. 7A through 7H are exemplary only and are not drawn to scale. Such skilled persons will further appreciate that many variations are possible such as, for example, memory cell control lines could be built in a different layer rather than the same layer. Moreover, the stacked memory layers may be connected to a periphery circuit that is above the memory stack. Additionally, each tier of memory could be configured with a slightly different donor wafer N+ layer doping profile. Further, the memory could be organized in a different manner, such as BL and SL interchanged, or these architectures could be modified into a NOR flash memory style, or where buried wiring for the memory array is below the memory layers but above the periphery. Many other modifications within the scope of the invention will suggest themselves to such skilled persons after reading this specification.

The monolithic 3D integration concepts described in this patent application can lead to novel embodiments of poly-crystalline silicon based memory architectures.

As illustrated in Fig. 3E, oxide 322, third Si/SiO2 layer, second Si/SiO2 layer and first Si/SiO2 layer may be lithographically defined and plasma/RIE etched to form a portion of the memory cell structure, which now includes multiple layers of regions of crystallized N+ silicon 321 and oxide 322. Thus, these transistor elements or portions have been defined by a common lithography step, which also may be described as a single lithography step, same lithography step, or one lithography step.

As illustrated in Fig. 3F, a gate dielectric and gate electrode material may be deposited, planarized with a chemical mechanical polish (CMP), and then lithographically defined and plasma/RIE etched to form gate dielectric regions 326 which may either be self-aligned to and covered by gate electrodes 324 (shown), or cover the entire crystallized N+ silicon regions 321 and oxide regions 322 multi-layer structure. The gate stack including gate electrode 324 and gate dielectric 326 may be formed with a gate dielectric, such as thermal oxide, and a gate electrode material, such as poly-crystalline silicon. Alternatively, the gate dielectric may be an atomic layer deposited (ALD) material that is paired with a work function specific gate metal according to an industry standard of high k metal gate process schemes described previously. Furthermore, the gate dielectric may be formed with a rapid thermal oxidation (RTO), a low temperature oxide deposition or low temperature microwave plasma oxidation of the silicon surfaces and then a gate electrode such as tungsten or aluminum may be deposited.

As illustrated in Fig. 3G, the entire structure may be covered with a gap fill oxide 330, which may be planarized with chemical mechanical polishing. The oxide 330 is shown transparently in the figure for clarity, along with word-line regions (WL) 332, coupled with and composed of gate electrodes 324, and source-line regions (SL) 334, composed of crystallized N+ silicon regions 328.

As illustrated in Fig. 3H, bit-line (BL) contacts 340 maybe lithographically defined, etched with plasma/RIE through oxide 330, the three crystallized N+ silicon regions 328, and associated oxide vertical isolation regions to connect substantially all memory layers vertically, and photoresist removed. Resistance change memory material 336, such as, for example, hafnium oxides or titanium oxides, may then be deposited, preferably with atomic layer deposition (ALD). The electrode for the resistance change memory element may then be deposited by ALD to form the electrode/BL contact 340. The excess deposited material may be polished to planarity at or below the top of oxide 330. Each BL contact 340 with resistive change material 336 may be shared among substantially all layers of memory, shown as three layers of memory in Fig. 3H.

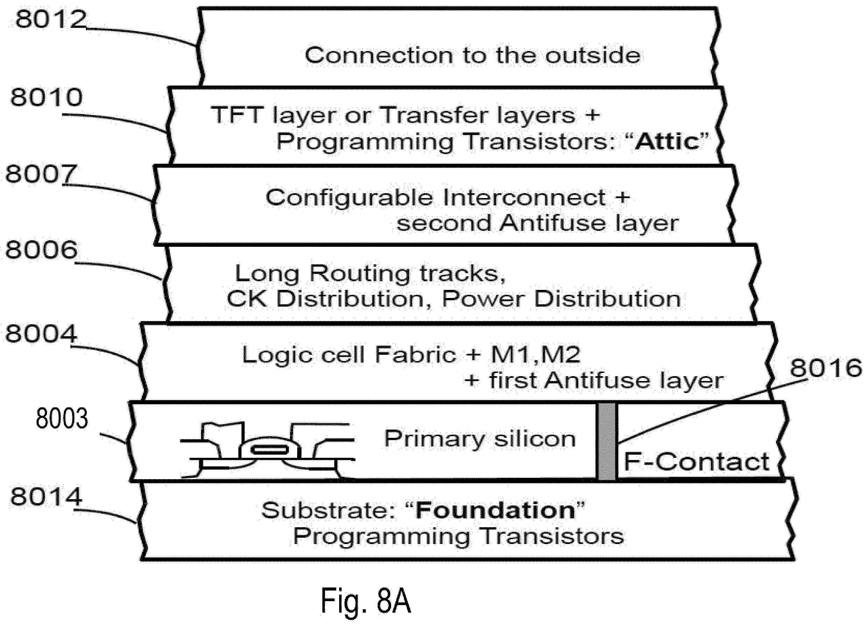

FIG. 8A is a drawing illustration of alternative implementation of the current invention, with Anti Fuses ("AF"s) present in two dielectric layers. Here the functional transistors of the Logic Blocks ("LB") are defined in the base substrate 8003, with low metal layers 8004 (M1 & M2 in this depiction, can be more as needed) providing connectivity for the definition of the LB. AFs are present in select locations between metal layers of low metal layers 8004 to assist in finalizing the function of the LB. AFs in low metal layers 8004 can also serve to configure clocks and other special signals (e.g., reset) present in layer 8006 for connection to the LB and other special functions that do not require high density programmable connectivity to the configurable interconnect fabric 8007. Additional AF use can be to power on used LBs and unpower unused ones to save on power dissipation of the device.

**On** top of layer 8006 comes configurable interconnect fabric 8007 with a second Antifuse layer. This connectivity is typically occupying two or four metal layers. Programming of AFs in both layers is done with programming circuitry designed in an Attic TFT layer 8010, or other alternative over the oxide transistors, placed on top of configurable interconnect fabric 8007. Finally, additional metals layers 8012 are deposited on top of Attic TFT layer 8010 to complete the programming circuitry in Attic TFT layer 8010, as well as provide connections to the outside for the FPGA.

**The** advantage of this alternative implementation is that two layers of AFs provide increased programmability (and hence flexibility) for FPGA, with the lower AF layer close to the base substrate where LB configuration needs to be done, and the upper AF layer close to the metal layers comprising the configurable interconnect.

US Patents 5374564 and 6528391, describe the process of Layer Transfer whereby a few tens or hundreds nanometer thick layer of mono-crystalline silicon from "donor" wafer is transferred on top of a base wafer using oxide-oxide bonding and ion implantation. Such a process, for example, is routinely used in the industry to fabricate the so-called Silicon-on-Insulator ("SOI") wafers for high performance integrated circuits ("IC"s).

Additionally the substrate 8002 in FIG. 8A is a primary silicon layer 8003 placed on top of an insulator above base substrate 8014 using the abovementioned Layer Transfer process.

**In** contrast to the typical SOI process where the base substrate carries no circuitry, the current invention suggest to use base substrate 8014 to provide high voltage programming circuits that will program the lower level low metal layers 8004 of AFs. We will use the term "Foundation" to describe this layer of programming devices, in contrast to the "Attic" layer of programming devices placed on top that has been previously described.

**The** major obstacle to using circuitry in the Foundation is the high temperature potentially needed for Layer Transfer, and the high temperature needed for processing the primary silicon layer 8003. High temperatures in excess of 400°C that are often needed for implant activation or other processing can cause damage to pre-existing copper or aluminum metallization patterns that may have been previously fabricated in Foundation base substrate 8014. U.S. Patent Application Publication 2009/0224364 proposes using tungsten-based metallization to complete the wiring of the relatively simple circuitry in the Foundation. Tungsten has very high melting temperature and can withstand the high temperatures that may be needed for both for Layer Transfer and for processing of primary silicon layer 8003. Because the Foundation provides mostly the programming circuitry for AFs in low metal layers 8004, its lithography can be less advanced and less expensive than that of the primary silicon layer 8003 and facilitates fabrication of high voltage devices needed to program AFs. Further, the thinness and hence the transparency of the SOI layer facilitates precise alignment of patterning of primary silicon layer 8003 to the underlying patterning of base substrate 8014.

Having two layers of AF-programming devices, Foundation on the bottom and Attic on the top, is an effective way to architect AF-based FPGAs with two layers of AFs. The first AF layer low metal layers 8004 is close to the primary silicon base substrate 8003 that it configures, and its connections to it and to the Foundation programming devices in base substrate 8014 are directed downwards. The second layer of AFs in configurable interconnect fabric 8007 has its programming connections directed upward towards Attic TFT layer 8010. This way the AF connections to its programming circuitry minimize routing congestion across layers 8003, 8004, 8006, and 8007.

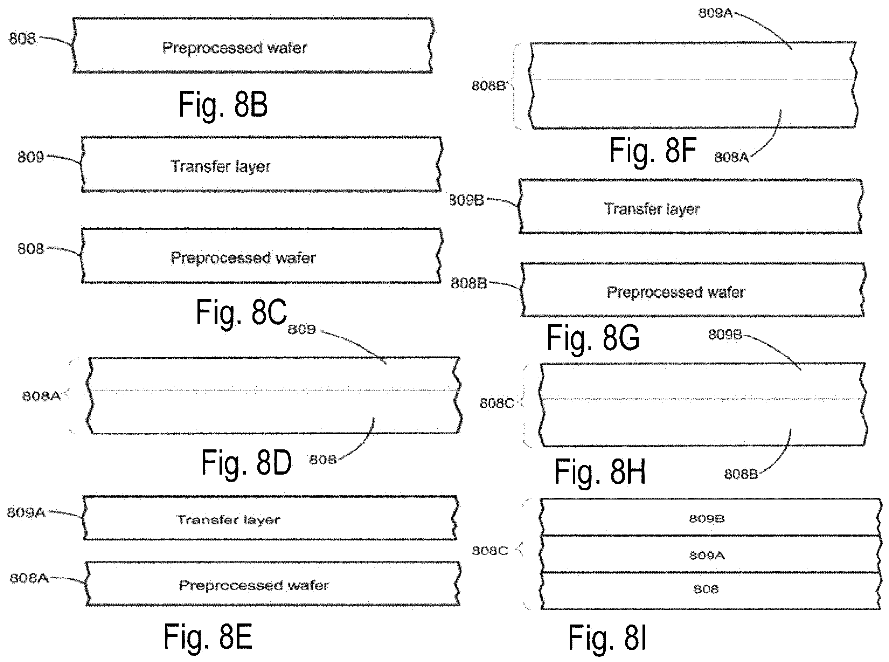

**Fig.** 8B is a drawing illustration of a generalized preprocessed wafer or layer 808. The wafer or layer 808 may have preprocessed circuitry, such as, for example, logic circuitry, microprocessors, circuitry comprising transistors of various types, and other types of digital or analog circuitry including, but not limited to, the various embodiments described herein. Preprocessed wafer or layer 808 may have preprocessed metal interconnects and may be comprised of copper or aluminum. The metal layer or layers of interconnect may be constructed of lower (less than approximately 400°C) thermal damage resistant metals such as, for example, copper or aluminum, or may be constructed with refractory metals such as tungsten to provide high temperature utility at greater than approximately 400°C. The preprocessed metal interconnects may be designed and prepared for layer transfer and electrical coupling from preprocessed wafer or layer 808 to the layer or layers to be transferred.

**The** reference 808 in subsequent figures can be any one of a vast number of combinations of possible preprocessed wafers or layers containing many combinations of transfer layers that fall within the scope of the present invention. The term "preprocessed wafer or layer" may be generic and reference number 808 when used in a drawing figure to illustrate an embodiment of the present invention may represent many different preprocessed wafer or layer types including but not limited to underlying prefabricated layers, a lower layer interconnect wiring, a base layer, a substrate layer, a processed house wafer, an acceptor wafer, a logic house wafer, an acceptor wafer house, an acceptor substrate, target wafer, preprocessed circuitry, a preprocessed circuitry acceptor wafer, a base wafer layer, a lower layer, an underlying main wafer, a foundation layer, an attic layer, or a house wafer.

**Fig.** 8C is a drawing illustration of a generalized transfer layer 809 prior to being attached to preprocessed wafer or layer 808. Transfer layer 809 may be attached to a carrier wafer or substrate during layer transfer. Preprocessed wafer or layer 808 may be called a target wafer, acceptor substrate, or acceptor wafer. The acceptor wafer may have acceptor wafer metal connect pads or strips designed and prepared for electrical coupling to transfer layer 809. Transfer layer 809 may be attached to a carrier wafer or substrate during layer transfer. Transfer layer 809 may have metal interconnects designed and prepared for layer transfer and electrical coupling to preprocessed wafer or layer 808. The metal interconnects now on transfer layer 809 may be comprised of copper or aluminum. Electrical coupling from transferred layer 809 to preprocessed wafer or layer 808 may utilize thru layer vias (TLVs) as the connection path. Transfer layer 809 may be comprised of single crystal silicon, or mono-crystalline silicon, or doped mono-crystalline layer or layers, or other semiconductor, metal, and insulator materials, layers; or multiple regions of single crystal silicon, or mono-crystalline silicon, or dope mono-crystalline silicon, or other semiconductor, metal, or insulator materials.

**Fig.** 8D is a drawing illustration of a preprocessed wafer or layer 808A created by the layer transfer of transfer layer 809 on top of preprocessed wafer or layer 808. The top of preprocessed wafer or layer 808A may be further processed with metal interconnects designed and prepared for layer transfer and electrical coupling from preprocessed wafer or layer 808A to the next layer or layers to be transferred.

**Fig.** 8E is a drawing illustration of a generalized transfer layer 809A prior to being attached to preprocessed wafer or layer 808A. Transfer layer 809A may be attached to a carrier wafer or substrate during layer transfer. Transfer layer 809A may have metal interconnects designed and prepared for layer transfer and electrical coupling to preprocessed wafer or layer 808A.

**Fig.** 8F is a drawing illustration of a preprocessed wafer or layer 808B created by the layer transfer of transfer layer 809A on top of preprocessed wafer or layer 808A. The top of preprocessed wafer or layer 808B may be further processed with metal interconnects designed and prepared for layer transfer and electrical coupling from preprocessed wafer or layer 808B to the next layer or layers to be transferred.

**Fig.** 8G is a drawing illustration of a generalized transfer layer 809B prior to being attached to preprocessed wafer or layer 808B. Transfer layer 809B may be attached to a carrier wafer or substrate during layer transfer. Transfer layer 809B may have metal interconnects designed and prepared for layer transfer and electrical coupling to preprocessed wafer or layer 808B.

**Fig.** 8H is a drawing illustration of preprocessed wafer layer 808C created by the layer transfer of transfer layer 809B on top of preprocessed wafer or layer 808B. The top of preprocessed wafer or layer 808C may be further processed with metal interconnect designed and prepared for layer transfer and electrical coupling from preprocessed wafer or layer 808C to the next layer or layers to be transferred.

**Fig.** 8I is a drawing illustration of preprocessed wafer or layer 808C, a 3D IC stack, which may comprise transferred layers 809A and 809B on top of the original preprocessed wafer or layer 808. Transferred layers 809A and 809B and the original preprocessed wafer or layer 808 may comprise transistors of one or more types in one or more layers, metallization such as, for example, copper or aluminum in one or more layers, interconnections to and between layers above and below, and interconnections within the layer. The transistors may be of various types that may be different from layer to layer or within the same layer. The transistors may be in various organized patterns. The transistors may be in various pattern repeats or bands. The transistors may be in multiple layers involved in the transfer layer. The transistors may be junction-less transistors or recessed channel array transistors. Transferred layers 809A and 809B and the original preprocessed wafer or layer 808 may further comprise semiconductor devices such as resistors and capacitors and inductors, one or more programmable interconnects, memory structures and devices, sensors, radio frequency devices, or optical interconnect with associated transceivers. The terms carrier wafer or carrier substrate may also be called holder wafer or holder substrate.

**This** layer transfer process can be repeated many times, thereby creating preprocessed wafers comprising many different transferred layers which, when combined, can then become preprocessed wafers or layers for future transfers. This layer transfer process may be sufficiently flexible that preprocessed wafers and transfer layers, if properly prepared, can be flipped over and processed on either side with further transfers in either direction as a matter of design choice.

The thinner the transferred layer, the smaller the thru layer via diameter obtainable, due to the limitations of manufacturable via aspect ratios. Thus, the transferred layer may be, for example, less than 2 microns thick, less than 1 micron thick, less than 0.4 microns thick, less than 200nm thick, or less than 100nm thick. The thickness of the layer or layers transferred according to some embodiments of the present invention may be designed as such to match and enable the best obtainable lithographic resolution capability of the manufacturing process employed to create the thru layer vias or any other structures on the transferred layer or layers.

**In** many of the embodiments of the present invention, the layer or layers transferred may be of mono-crystalline silicon, and after layer transfer, further processing, such as, for example, plasma/RIE or wet etching, may be done on the layer or layers that may create islands or mesas of the transferred layer or layers of mono-crystalline silicon, the crystal orientation of which has not changed. Thus, a mono-crystalline layer or layers of a certain specific crystal orientation may be layer transferred and then processed whereby the resultant islands or mesas of mono-crystalline silicon have the same crystal specific orientation as the layer or layers before the processing.

Persons of ordinary skill in the art will appreciate that the illustrations in Figs. 8 through 8I are exemplary only and are not drawn to scale. Such skilled persons will further appreciate that many variations are possible such as, for example, the preprocessed wafer or layer 808 may act as a base or substrate layer in a wafer transfer flow, or as a preprocessed or partially preprocessed circuitry acceptor wafer in a wafer transfer process flow. Many other modifications within the scope of the present invention will suggest themselves to such skilled persons after reading this specification. Thus the invention is to be limited only by the appended claims.

**An** alternative technology for such underlying circuitry is to use the "SmartCut" process. The "SmartCut" process is a well understood technology used for fabrication of SOI wafers. The "SmartCut" process, together with wafer bonding technology, enables a "Layer Transfer" whereby a thin layer of a single or mono-crystalline silicon wafer is transferred from one wafer to another wafer. The "Layer Transfer" could be done at less than 400°C and the resultant transferred layer could be even less than 100nm thick. The process with some variations and under different names is commercially available by two companies, namely, Soitec (Crolles, France) and SiGen - Silicon Genesis Corporation (San Jose, CA). A room temperature wafer bonding process utilizing ion-beam preparation of the wafer surfaces in a vacuum has been recently demonstrated by Mitsubishi Heavy Industries Ltd., Tokyo, Japan. This process allows room temperature layer transfer.

Alternatively, other technology may also be used. For example, other technologies may be utilized for layer transfer as described in, for example, IBM's layer transfer method shown at IEDM 2005 by A.W. Topol, et. al. The IBM's layer transfer method employs a SOI technology and utilizes glass handle wafers. The donor circuit may be high-temperature processed on an SOI wafer, temporarily bonded to a borosilicate glass handle wafer, backside thinned by chemical mechanical polishing of the silicon and then the Buried Oxide (BOX) is selectively etched off. The now thinned donor wafer is subsequently aligned and low-temperature oxide-to-oxide bonded to the acceptor wafer topside. A low temperature release of the glass handle wafer from the thinned donor wafer is performed, and then thru bond via connections are made. Additionally, epitaxial liftoff (ELO) technology as shown by P.Demeester, et.al, of IMEC in Semiconductor Science Technology 1993 may be utilized for layer transfer. ELO makes use of the selective removal of a very thin sacrificial layer between the substrate and the layer structure to be transferred. The to-be-transferred layer of GaAs or silicon may be adhesively 'rolled' up on a cylinder or removed from the substrate by utilizing a flexible carrier, such as, for example, black wax, to bow up the to-be-transferred layer structure when the selective etch, such as, for example, diluted Hydrofluoric (HF) Acid, etches the exposed release layer, such as, for example, silicon oxide in SOI or AlAs. After liftoff, the transferred layer is then aligned and bonded to the acceptor substrate or wafer. The manufacturability of the ELO process for multilayer layer transfer use was recently improved by J. Yoon, et. al., of the University of Illinois at Urbana-Champaign as described in Nature May 20, 2010. Canon developed a layer transfer technology called ELTRAN - Epitaxial Layer TRANsfer from porous silicon. ELTRAN may be utilized. The Electrochemical Society Meeting abstract No. 438 from year 2000 and the JSAP International July 2001 paper show a seed wafer being anodized in an HF/ethanol solution to create pores in the top layer of silicon, the pores are treated with a low temperature oxidation and then high temperature hydrogen annealed to seal the pores. Epitaxial silicon may then be deposited on top of the porous silicon and then oxidized to form the SOI BOX. The seed wafer may be bonded to a handle wafer and the seed wafer may be split off by high pressure water directed at the porous silicon layer. The porous silicon may then be selectively etched off leaving a uniform silicon layer.

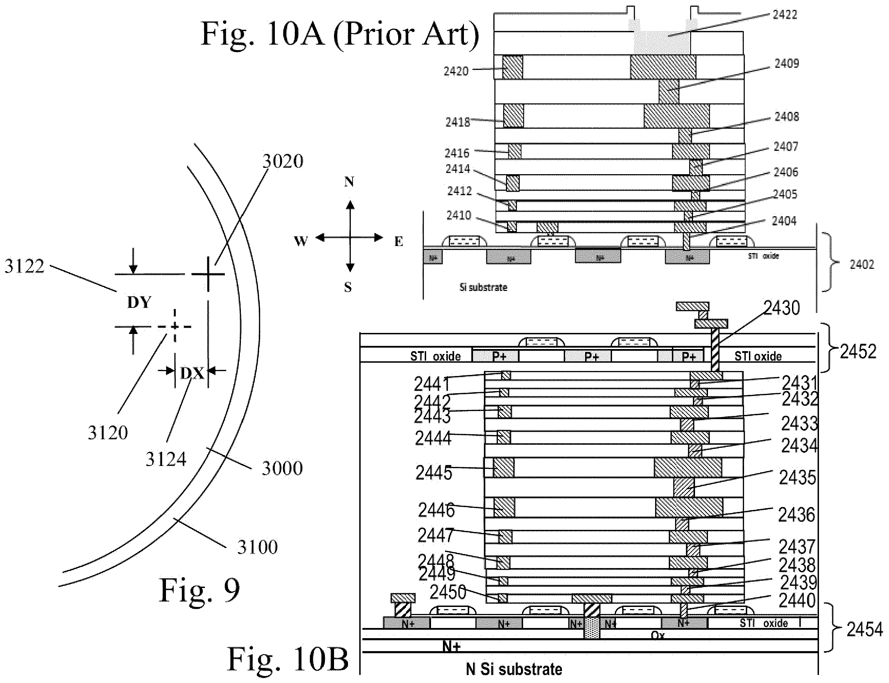

Fig. 9 illustrate the main wafer 3100 with its alignment mark 3120 and the transferred layer 3000 of the donor wafer 3000 with its alignment mark 3020. The misalignment in the East-West direction is DX 3124 and the misalignment in the North-South direction is DY 3122. For simplicity of the following explanations, the alignment marks 3120 and 3020 may be assumed set so that the alignment mark of the transferred layer 3020 is always north of the alignment mark of the base wafer 3120, though the cases where alignment mark 3020 is either perfectly aligned with (within tolerances) or south of alignment mark 3120 are handled in an appropriately similar manner. In addition, these alignment marks may be placed in only a few locations on each wafer, within each step field, within each die, within each repeating pattern W, or in other locations as a matter of design choice.

**In** the construction of this described monolithic 3D Integrated Circuits the objective is to connect structures built on layer 3000 to the underlying main wafer 3100 and to structures on 808 layers at about the same density and accuracy as the connections between layers in 808, which may need alignment accuracies on the order of tens of nm or better.

Additionally, when circuit cells are built on two or more layers of thin silicon, and enjoy the dense vertical through silicon via interconnections, the metallization layer scheme to take advantage of this dense 3D technology may be improved as follows. Fig. 10A illustrates the prior art of silicon integrated circuit metallization schemes. The conventional transistor silicon layer 2402 is connected to the first metal layer 2410 thru the contact 2404. The dimensions of this interconnect pair of contact and metal lines generally are at the minimum line resolution of the lithography and etch capability for that technology process node. Traditionally, this is called a "1X' design rule metal layer. Usually, the next metal layer is also at the "1X' design rule, the metal line 2412 and via below 2405 and via above 2406 that connects metal line 2412 with 2410 or with 2414 where desired. Then the next few layers are often constructed at twice the minimum lithographic and etch capability and called '2X' metal layers, and have thicker metal for current carrying capability. These are illustrated with metal line 2414 paired with via 2407 and metal line 2416 paired with via 2408 in Fig. 10A. Accordingly, the metal via pairs of 2418 with 2409, and 2420 with bond pad opening 2422, represent the '4X' metallization layers where the planar and thickness dimensions are again larger and thicker than the 2X and 1X layers. The precise number of 1X or 2X or 4X layers may vary depending on interconnection needs and other requirements; however, the general flow is that of increasingly larger metal line, metal space, and via dimensions as the metal layers are farther from the silicon transistors and closer to the bond pads.

**The** metallization layer scheme may be improved for 3D circuits as illustrated in Fig. 10B. The first crystallized silicon device layer 2454 is illustrated as the NMOS silicon transistor layer from the above 3D library cells, but may also be a conventional logic transistor silicon substrate or layer. The '1X' metal layers 2450 and 2449 are connected with contact 2440 to the silicon transistors and vias 2438 and 2439 to each other or metal 2448. The 2X layer pairs metal 2448 with via 2437 and metal 2447 with via 2436. The 4X metal layer 2446 is paired with via 2435 and metal 2445, also at 4X. However, now via 2434 is constructed in 2X design rules to enable metal line 2444 to be at 2X. Metal line 2443 and via 2433 are also at 2X design rules and thicknesses. Vias 2432 and 2431 are paired with metal lines 2442 and 2441 at the 1X minimum design rule dimensions and thickness. The thru silicon via 2430 of the illustrated PMOS layer transferred silicon layer 2452 may then be constructed at the 1X minimum design rules and provide for maximum density of the top layer. The precise numbers of 1X or 2X or 4X layers may vary depending on circuit area and current carrying metallization requirements and tradeoffs. However, the pitch, line-space pair, of a 1X layer is less than the pitch of a 2X layer which is less than the pitch of the 4X layer. The illustrated PMOS layer transferred silicon layer 2452 may be any of the low temperature devices illustrated herein.

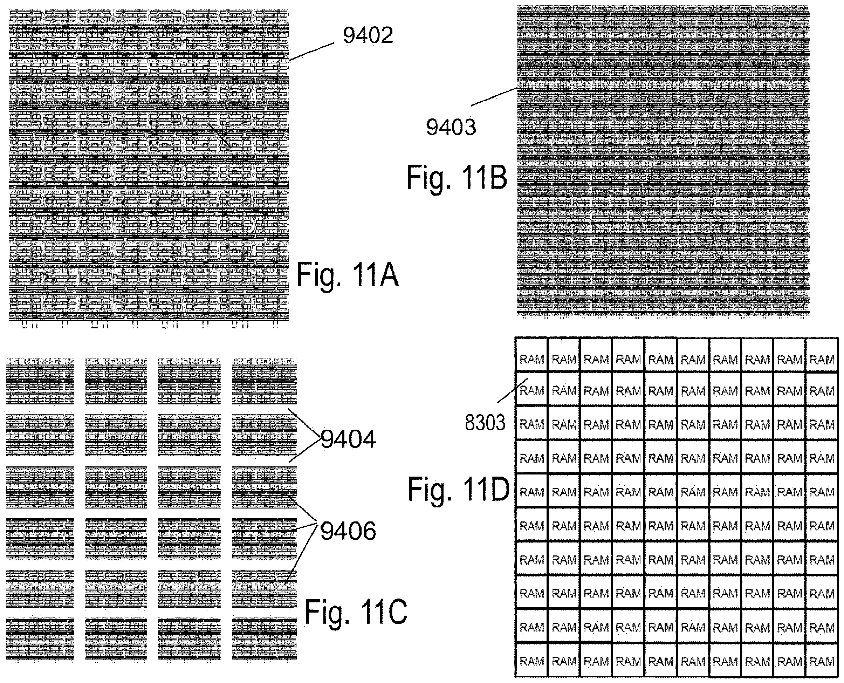

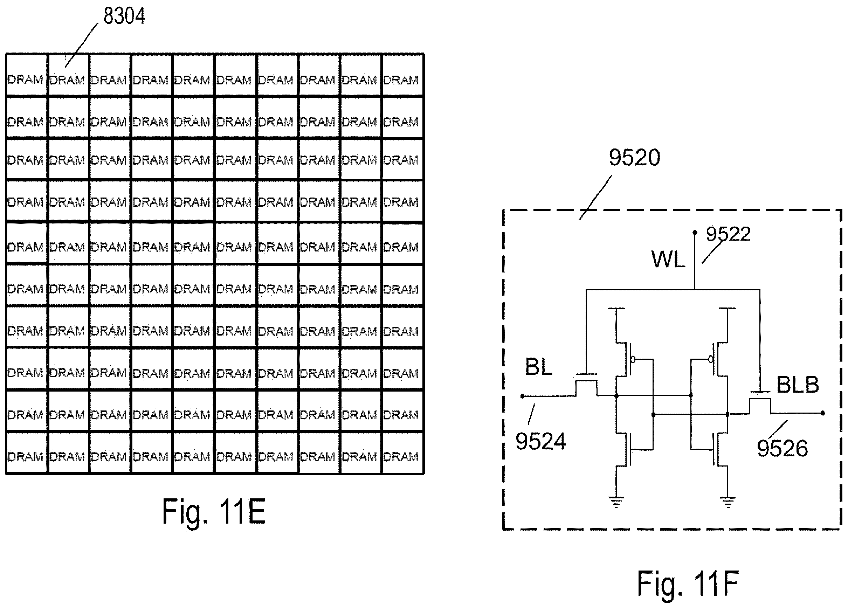

**FIG.** 11A is a drawing illustration of extending the structure of an 8x12 array 9402. This can be extended as in FIG. 11B to fill a full reticle sized area 9403. Accordingly a specific custom device may be diced from the previously generic wafer. The custom dice lines may be created by etching away some of the structures such as transistors of the continuous array as illustrated in FIG 11C. This custom function etching may have a shape of multiple thin strips 9404 created by a custom mask, such as a dicing line mask, to etch away a portion of the devices. Thus custom forming logic function, blocks, arrays, or devices 9406 (for clarity, not all possible blocks are labeled). A portion of these logic functions, blocks, arrays, or devices 9406 may be interconnected horizontally with metallization and may be connected to circuitry above and below using TSV or utilizing the monolithic 3D variation, including the embodiments in this document. This custom function alternative has some advantages relative to the use of the previously described potential dice lines, such as, the saving of the allocated area for the unused dice lines and the saving of the mask and the processing of the interconnection over the unused dice lines. However, in both variations substantial savings would be achieved relative to the state of the art. The state of art for FPGA vendors, as well as some other products, is that for a product release for a specific process node more than ten variations would be offered by the vendor. These variations use the same logic fabric applied to different devices sizes offering various amount of logic. In many cases, the variation also includes the amount of memories and I/O cells. State of the art IC devices require more than 30 different masks at a typical total mask set cost of a few million dollars. For a vendor to offer the multiple device option, it would require substantial investment in multiple mask sets. The current invention allows the use of a generic continuous array and then a customization process would be applied to construct multiple device sizes out of the same mask set. Therefore, for example, a continuous array as illustrated in FIG. 11B is customized to a specific device size by etching the multiple thin strips 9404 as illustrated in FIG. 11C. This could be done to various types of continuous terrains as illustrated in FIG. 11D-11E having array of Random Access Memory ("RAM") 8303 or array of Dynamic Random Access Memory ("DRAM") 8304. Accordingly, wafers may be processed using one generic mask set of more than ten masks and then multiple device offerings may be constructed by few custom function masks which would define specific sizes out of the generic continues array structure. And, accordingly, the wafer may then be diced to a different size for each device offering.

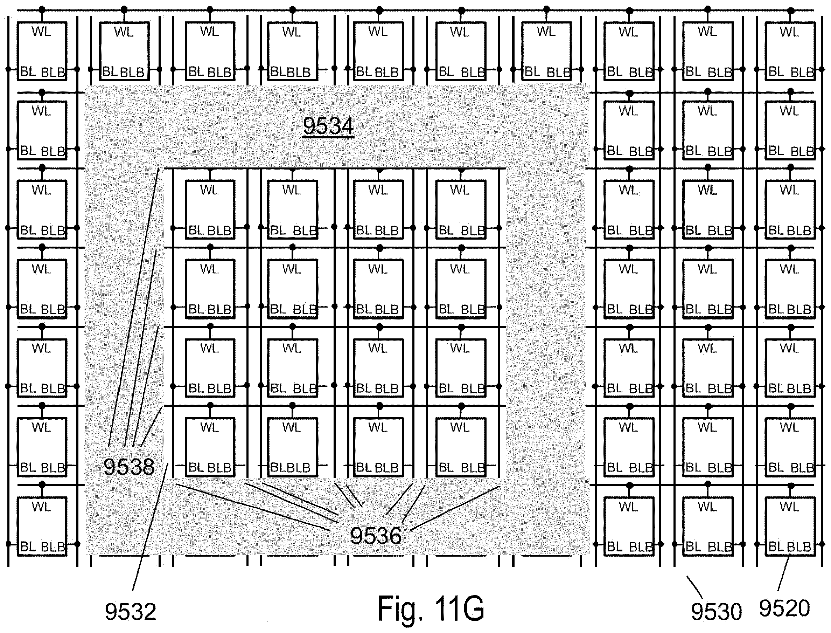

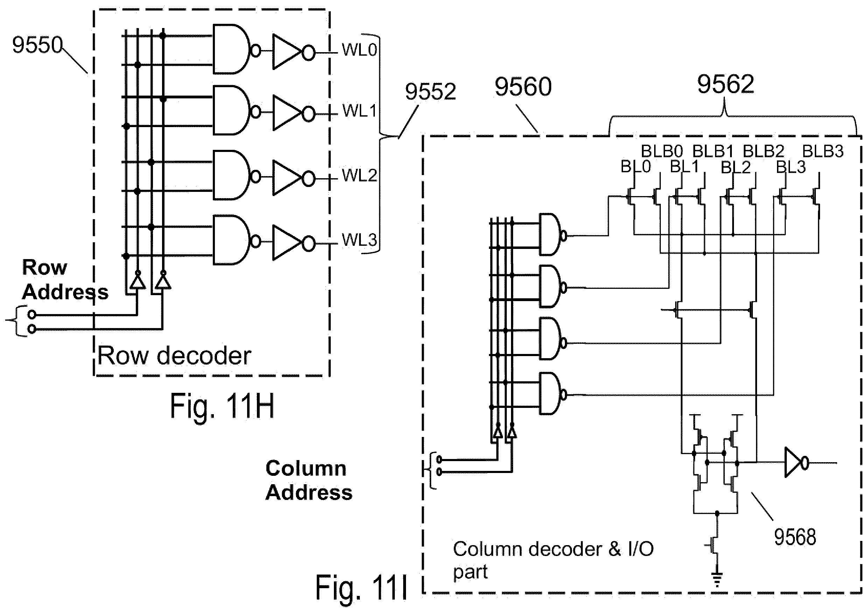

**The** concept of customizing a Continuous Array can be also applied to logic, memory, I/O and other structures. Memory arrays have non-repetitive elements such as bit and word decoders, or sense amplifiers, which need to be tailored to each memory size. An embodiment of the present invention is to tile substantially the entire wafer with a dense pattern of memory cells, and then customize it using selective etching as before, and providing the required non-repetitive structures through an adjacent logic layer below or above the memory layer. FIG. 11F is a drawing illustration of a typical 6-transistor SRAM cell 9520, with its word line 9522, bit line 9524 and bit line inverse 9526. Such a bit cell is typically densely packed and highly optimized for a given process. A dense SRAM array 9530 may be constructed of a plurality of 6-transistor SRAM cell 9520 as illustrated in FIG. 11G. A four by four array 9532 may be defined through custom etching away the cells in channel 9534, leaving bit lines 9536 and word lines 9538 unconnected. These word lines 9538 may be then connected to an adjacent logic layer below or above that may have a word decoder 9550 (depicted in FIG. 11H) that may drive them through outputs 9552. Similarly, the bit lines 9536 may be driven by another decoder such as bit line decoder 9560 (depicted in FIG. 11I) through its outputs 9562. A sense amplifier 9568 is also shown. A critical feature of this approach is that the customized logic, such as word decoder 9550, bit line decoder 9560, and sense amplifier 9568, may be provided from below or above the memory layer/devices in close vertical proximity to the area where it is needed, thus assuring high performance customized memory blocks.

One method to solve the issue of high-temperature source-drain *junction* processing is to make transistors without junctions i.e. Junction-Less Transistors (JLTs). An embodiment of this invention uses JLTs as a building block for 3D stacked semiconductor circuits and chips. JLT has a very small channel area (typically less than 20nm on one side), so the gate can deplete the channel of charge carriers at 0V and turn it off. Further details of the JLT can be found in "Junctionless multigate field-effect transistor," Appl. Phys. Lett., vol. 94, pp. 053511 2009 by C.-W. Lee , A. Afzalian , N. Dehdashti Akhavan , R. Yan , I. Ferain and J. P. Colinge ("C-W. Lee"). Contents of this publication are incorporated herein by reference.

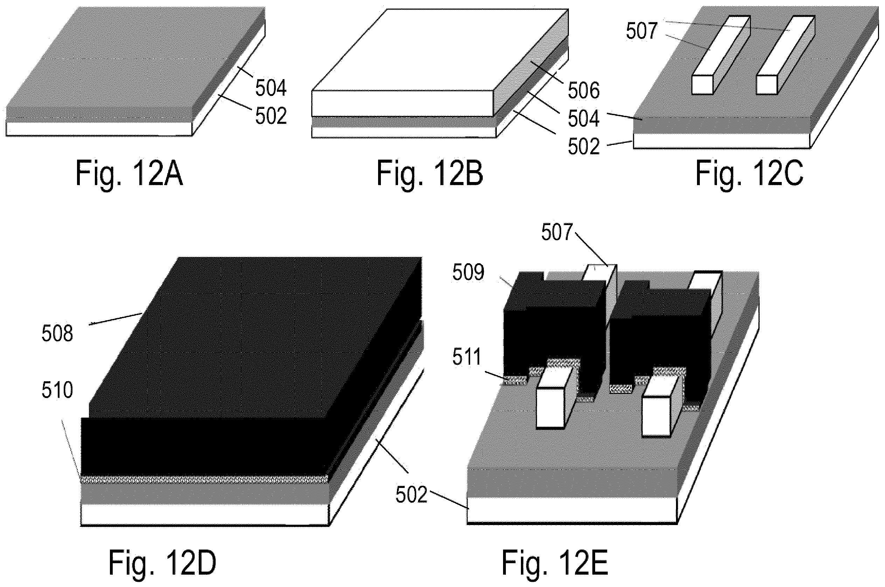

Fig. 12A-E describes a process flow for constructing 3D stacked circuits and chips using JLTs as a building block. The process flow may comprise several steps, as described in the following sequence:
Step (A): The bottom layer of the 3D stack is processed with transistors and wires. This is indicated in the figure as bottom layer of transistors and wires 502. Above this, a silicon dioxide layer 504 is deposited. Fig. 12A shows the structure after Step (A) is completed.
Step (B): A layer of n+ Si 506 is transferred atop the structure shown after Step (A). It starts by taking a donor wafer which is already n+ doped and activated. Alternatively, the process can start by implanting a silicon wafer and activating at high temperature forming an n+ activated layer, which may be conductive or semi-conductive. Then, H+ ions are implanted for ion-cut within the n+ layer. Following this, a layer transfer is performed. The process as shown in Fig. 1A-D and Fig. 2 is utilized for transferring and ion-cut of the layer forming the structure of Fig. 12A. Fig. 12B illustrates the structure after Step (B) is completed.
Step (C): Using lithography (litho) and etch, the n+ Si layer is defined and is present only in regions where transistors are to be constructed. These transistors are aligned to the underlying alignment marks embedded in bottom layer of transistors and wires 502. Fig. 12C illustrates the structure after Step (C) is completed, showing structures of the gate dielectric material 511 and gate electrode material 509 as well as structures of the n+ silicon region 507 after Step (C).
Step (D): The gate dielectric material 510 and the gate electrode material 508 are deposited, following which a CMP process is utilized for planarization. The gate dielectric material 510 could be hafnium oxide. Alternatively, silicon dioxide can be used. Other types of gate dielectric materials such as Zirconium oxide can be utilized as well. The gate electrode material could be Titanium Nitride. Alternatively, other materials such as TaN, W, Ru, TiAlN, polysilicon could be used. Fig. 12D illustrates the structure after Step (D) is completed.
Step (E): Litho and etch are conducted to leave the gate dielectric material and the gate electrode material only in regions where gates are to be formed. Fig. 12E illustrates the structure after Step (E) is completed. Final structures of the gate dielectric material 511 and gate electrode material 509 are shown.
Step (F): An oxide layer is deposited and polished with CMP. This oxide region serves to isolate adjacent transistors. Following this, rest of the process flow continues, where contact and wiring layers could be formed.

Note that top-level transistors are formed well-aligned to bottom-level wiring and transistor layers. Since the top-level transistor layers are made very thin (preferably less than 200nm), the lithography equipment can see through these thin silicon layers and align to features at the bottom-level. While the process flow shown in Fig. 12A-12E gives the key steps involved in forming a JLT for 3D stacked circuits and chips, it is conceivable to one skilled in the art that changes to the process can be made. For example, process steps and additional materials/regions to add strain to junction-less transistors can be added or a p+ silicon layer could be used. Furthermore, more than two layers of chips or circuits can be 3D stacked.

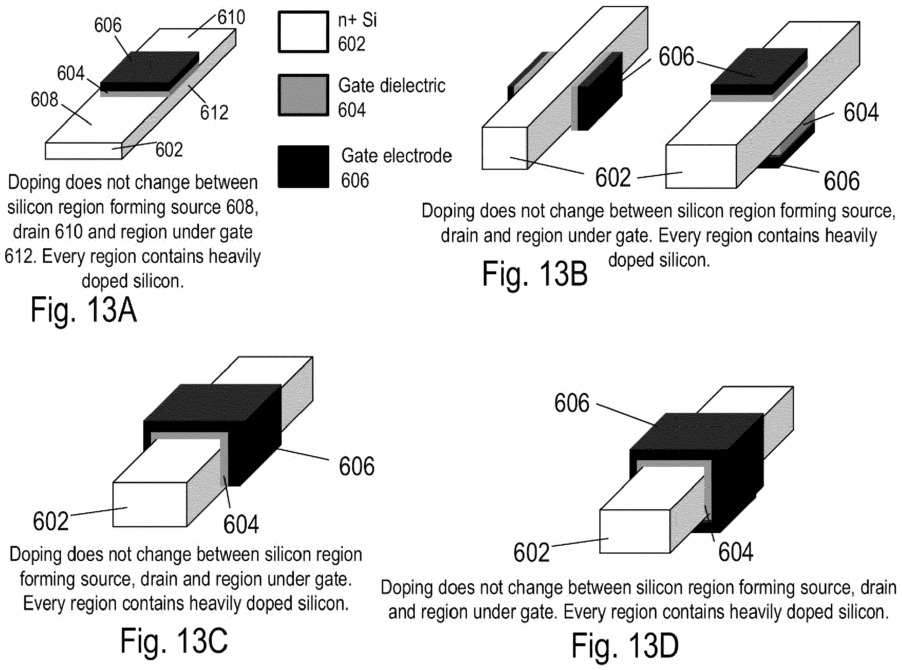

Fig. 13A-13D shows that JLTs that can be 3D stacked fall into four categories based on the number of gates they use: One-side gated JLTs as shown in Fig. 13A, two-side gated JLTs as shown in Fig. 13B, three-side gated JLTs as shown in Fig. 13C, and gate-all-around JLTs as shown in Fig. 13D. The JLT shown in Fig. 12A-E falls into the three-side gated JLT category. As the number of JLT gates increases, the gate gets more control of the channel, thereby reducing leakage of the JLT at 0V. Furthermore, the enhanced gate control can be traded-off for higher doping (which improves contact resistance to source-drain regions) or bigger JLT cross-sectional areas (which is easier from a process integration standpoint).

Lithography costs for semiconductor manufacturing today form a dominant percentage of the total cost of a processed wafer. In fact, some estimates describe lithography cost as being more than 50% of the total cost of a processed wafer. In this scenario, reduction of lithography cost is very important.

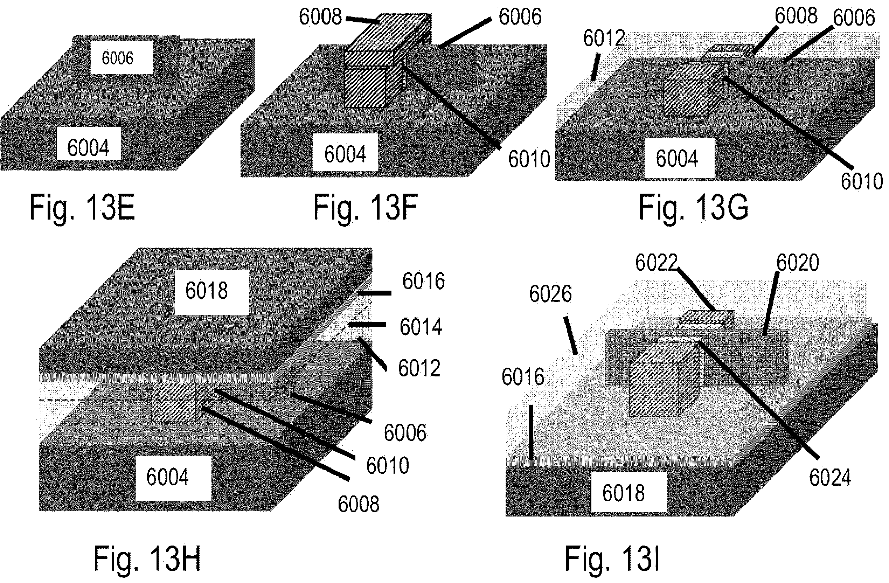

Fig. 13E-13I describes an embodiment of this invention, where a process flow is described in which a single lithography step is shared among many wafers. Although the process flow is described with respect to a side gated mono-crystalline junction-less transistor, it will be obvious to one with ordinary skill in the art that it can be modified and applied to other types of transistors, such as, for example, FINFETs and planar CMOS MOSFETs. The process flow for the silicon chip may include the following steps that occur in sequence from Step (A) to Step (I). When the same reference numbers are used in different drawing figures (among Fig. 13E-13I), they are used to indicate analogous, similar or identical structures to enhance the understanding of the present invention by clarifying the relationships between the structures and embodiments presented in the various diagrams - particularly in relating analogous, similar or identical functionality to different physical structures.
Step (A) A p- Silicon wafer is taken.
Step (B) N+ and p+ dopant regions may be implanted into the p- Silicon wafer. A thermal anneal, such as, for example, rapid, furnace, spike, or laser may then be done to activate dopants. Following this, a lithography and etch process may be conducted to define p- silicon substrate region 6004 and n+ silicon region 6006 as is illustrated in Fig. 13E. Regions with p+ silicon where p-JLTs are fabricated are not shown.
Step (C) is illustrated with Fig. 13F. Gate dielectric regions 6010 and gate electrode regions 6008 may be formed by oxidation or deposition of a gate dielectric, then deposition of a gate electrode, polishing with CMP and then lithography and etch. The gate electrode regions 6008 are preferably doped polysilicon. Alternatively, various hi-k metal gate (HKMG) materials could be utilized for gate dielectric and gate electrode.
Step (D) Silicon dioxide regions 6012 may be formed by deposition and may then be planarized and polished with CMP such that the silicon dioxide regions 6012 cover p- silicon substrate region 6004, n+ silicon regions 6006, gate electrode regions 6008 and gate dielectric regions 6010.
Step (E) as is illustrated with Fig. 13G. The structure may be further polished with CMP such that portions of silicon dioxide regions 6012, gate electrode regions 6008, gate dielectric regions 6010 and n+ silicon regions 6006 are polished. Following this, a silicon dioxide layer may be deposited over the structure.
Step (F) Hydrogen H+ may be implanted into the structure at a certain depth creating hydrogen plane 6014 indicated by dotted lines.
Step (G) A silicon wafer 6018 may have an oxide layer 6016 deposited atop it. Step (H) as is illustrated with Fig. 13H. The structure may be flipped and bonded atop the structure shown in Fig. 13F using oxide-to-oxide bonding.
Step (I) is illustrated with Fig. 13I. The structure shown in Fig. 13H may be cleaved at hydrogen plane 6014 using a sideways mechanical force. Alternatively, a thermal anneal, such as, for example, furnace or spike, could be used for the cleave process. Following the cleave process, CMP steps may be done to planarize surfaces. Fig. 13I shows silicon wafer 6018 having an oxide layer 6016 and patterned features transferred atop it. These patterned features may include gate dielectric regions 6024, gate electrode regions 6022, n+ silicon channel 6020 and silicon dioxide regions 6026. These patterned features may be used for further fabrication, with contacts, interconnect levels and other steps of the fabrication flow being completed. Implanting hydrogen through the gate dielectric regions 6010 may not degrade the dielectric quality, since the area exposed to implant species is small (a gate dielectric is typically 2nm thick, and the channel length is typically <20nm, so the exposed area to the implant species is just 40 sq. nm). Additionally, a thermal anneal or oxidation after the cleave may repair the potential implant damage. Also, a post-cleave CMP polish to remove the hydrogen rich plane within the gate dielectric may be performed.

An alternative embodiment of this invention may involve forming a dummy gate transistor structure, for the structure shown in Fig. 13F. Post cleave, the gate electrode regions 6022 and the gate dielectric regions 6024 material may be etched away and then the trench may be filled with a replacement gate dielectric and a replacement gate electrode.

In an alternative embodiment of the invention described in Fig. 13E-13I, the silicon wafer 6018 in Fig. 13H may be a wafer with one or more pre-fabricated transistor and interconnect layers. Low temperature (less than approximately 400°C) bonding and cleave techniques as previously described may be employed. In that scenario, 3D stacked logic chips may be formed with fewer lithography steps. Alignment schemes similar to those described may be used.

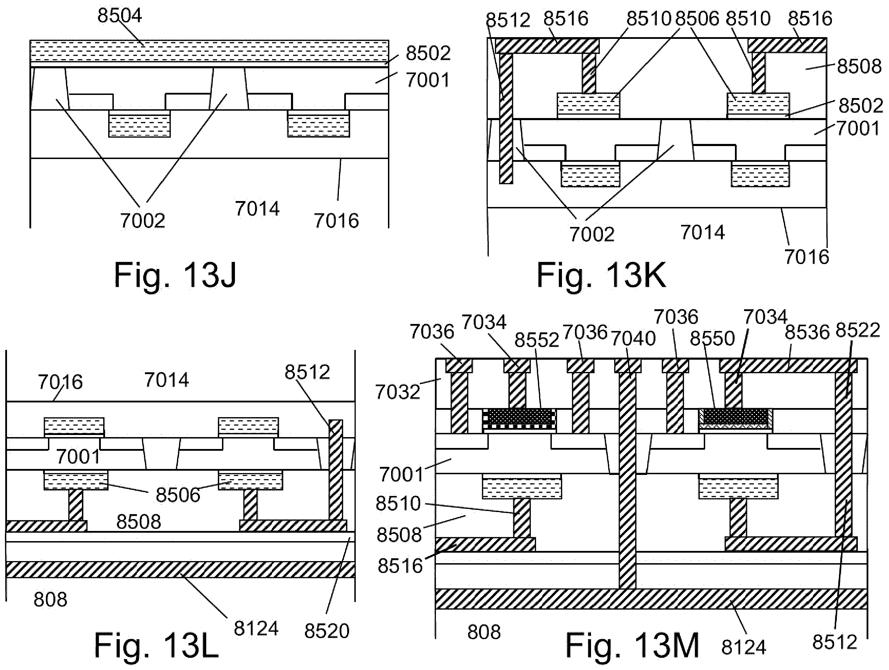

An alternative embodiment of the above double gate process flow that may provide a back gate in a face-up flow is illustrated in Figures 13J to 13M. The CMOS planar transistors may be fabricated with the dummy gates and cleave plane may be created in the donor wafer, bulk or SOI,. The donor wafer may be attached either permanently or temporarily to the carrier substrate and then cleaved and thinned to the STI 7002. Alternatively, the CMP could continue to the bottom of the junctions to create a fully depleted SOI layer.

A second gate oxide 8502 may be grown or deposited as illustrated in Figure 13J and a gate material 8504 may be deposited. The gate oxide 8502 and gate material 8504 may be formed with low temperature (e.g., less than 400°C) materials and processing, such as previously described TEL SPA gate oxide and amorphous silicon, ALD techniques, or hi-k metal gate stack (HKMG), or may be formed with a higher temperature gate oxide or oxynitride and doped polysilicon if the carrier substrate bond is permanent and the existing planar transistor dopant movement is accounted for.

The gate stack 8506 may be defined, a dielectric 8508 may be deposited and planarized, and then local contacts 8510 and layer to layer contacts 8512 and metallization 8516 may be formed as illustrated in Figure 13K.

As shown in Figure 13L, the thin mono-crystalline donor and carrier substrate stack may be prepared for layer transfer by methods previously described including oxide layer 8520. Similar surface preparation may be performed on house 808 acceptor wafer in preparation for oxide-to-oxide bonding. Now a low temperature (e.g., less than 400°C) layer transfer flow may be performed, as illustrated in Figure 13L, to transfer the thinned and first-phase-transistor-formation-pre-processed HKMG silicon layer 7001 and back gates 8506 with attached carrier substrate 7014 to the acceptor wafer 808. The acceptor wafer 808 may have a top metallization comprising metal strips 8124 to act as landing pads for connection between the circuits formed on the transferred layer with the underlying circuit layers 808.

The carrier substrate 7014 may then be released at surface 7016 as previously described.

The bonded combination of acceptor wafer 808 and HKMG transistor silicon layer 7001 may now be ready for normal state of the art gate-last transistor formation completion as illustrated in Figure 13M and connection to the acceptor wafer House 808 thru layer to layer via 7040. The top transistor 8550 may be back gated by connecting the top gate to the bottom gate thru gate contact 7034 to metal line 8536 and to contact 8522 to connect to the donor wafer layer through layer contact 8512. The top transistor 8552 may be back biased by connecting metal line 8516 to a back bias circuit that may be in the top transistor level or in the House 808. Moreover, SOI wafers with etchback of the bulk silicon to the buried oxide layer may be utilized in place of an ion-cut layer transfer scheme.

There are a few alternative methods to construct the top transistors precisely aligned to the underlying pre-fabricated layers such as pre-processed wafer or layer 808, utilizing "SmartCut" layer transfer and not exceeding the temperature limit, typically approximately 400°C, of the underlying pre-fabricated structure, which may include low melting temperature metals or other construction materials such as, for example, aluminum or copper. As the layer transfer is less than 200nm thick, then the transistors defined on it could be aligned precisely to the top metal layer of the pre-processed wafer or layer 808 as may be needed and those transistors have less than 40 nm misalignment as well as thru layer via, or layer to layer metal connection, diameters of less than 50nm. The thinner the transferred layer, the smaller the thru layer via diameter obtainable, due to the limitations of manufacturable via aspect ratios. Thus, the transferred layer may be, for example, less than 2 microns thick, less than 1 micron thick, less than 0.4 microns thick, less than 200nm thick, or less than 100nm thick.

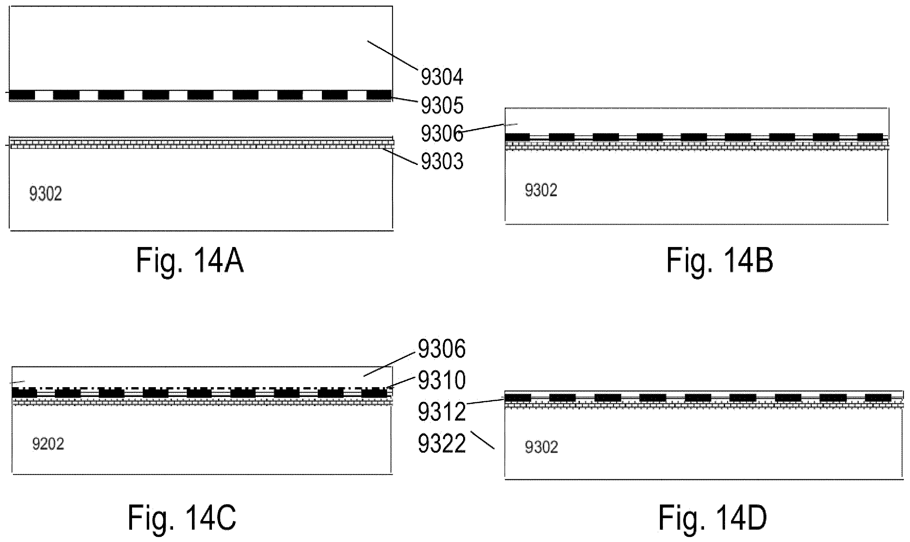

An additional embodiment of the present invention may be a modified TSV (Through Silicon Via) flow. This flow may be for wafer-to-wafer TSV and may provide a technique whereby the thickness of the added wafer may be reduced to about 1 micrometer (micron). Figs. 14A to 14D illustrate such a technique. The first wafer 9302 may be the base on top of which the 'hybrid' 3D structure may be built. A second wafer 9304 may be bonded on top of the first wafer 9302. The new top wafer may be face-down so that the circuits 9305 may be face-to-face with the first wafer 9302 circuits 9303.

The bond may be oxide-to-oxide in some applications or copper-to-copper in other applications. In addition, the bond may be by a hybrid bond wherein some of the bonding surface may be oxide and some may be copper.

After bonding, the top wafer 9304 may be thinned down to about 60 micron in a conventional back-lap and CMP process. Fig. 14B illustrates the now thinned wafer 9306 bonded to the first wafer 9302.

The next step may comprise a high accuracy measurement of the top wafer 9306 thickness. Then, using a high power 1-4MeV H+ implant, a cleave plane 9310 may be defined in the top wafer 9306. The cleave plane 9310 may be positioned approximately 1 micron above the bond surface as illustrated in Fig. 14C. This process may be performed with a special high power implanter such as, for example, the implanter used by SiGen Corporation for their PV (PhotoVoltaic) application.

Having the accurate measure of the top wafer 9306 thickness and the highly controlled implant process may enable cleaving most of the top wafer 9306 out thereby leaving a very thin layer 9312 of about 1 micron, bonded on top of the first wafer 9302 as illustrated in Fig. 14D.

An advantage of this process flow may be that an additional wafer with circuits could now be placed and bonded on top of the bonded structure 9322 in a similar manner. But first a connection layer may be built on the back of 9312 to allow electrical connection to the bonded structure 9322 circuits. Having the top layer thinned to a single micron level may allow such electrical connection metal layers to be fully aligned to the top wafer 9312 electrical circuits 9305 and may allows the vias through the back side of top layer 9312 to be relatively small, of about 100nm in diameter.

The thinning of the top layer 9312 may enable the modified TSV to be at the level of 100nm vs. the 5 microns necessary for TSVs that need to go through 50 microns of silicon. Unfortunately the misalignment of the wafer-to-wafer bonding process may still be quite significant at about +/-0.5 micron. Accordingly, a landing pad of approximately 1x1 microns may be used on the top of the first wafer 9302 to connect with a small metal contact on the face of the second wafer 9304 while using copper-to-copper bonding. This process may represent a connection density of approximately 1 connection per 1 square micron.

It may be desirable to increase the connection density using a concept as illustrated in Fig. 8A and the associated explanations. In the modified TSV case, it may be much more challenging to do so because the two wafers being bonded may be fully processed and once bonded, only very limited access to the landing strips may be available. However, to construct a via, etching through all layers may be needed.

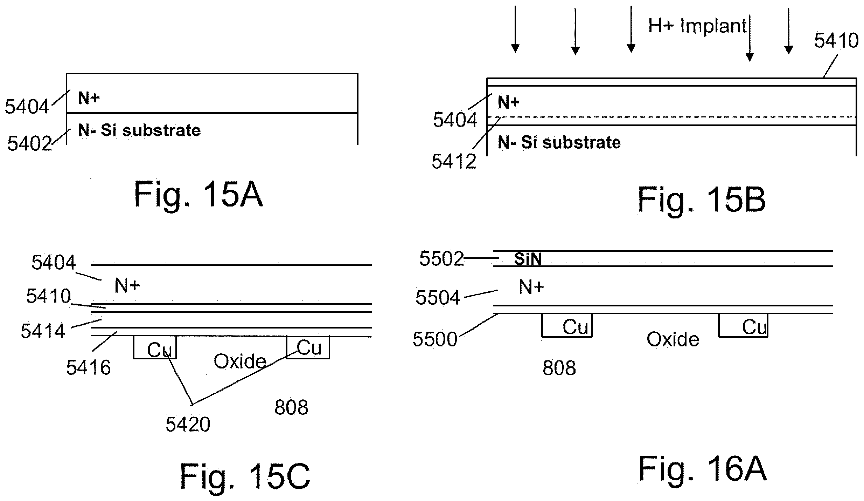

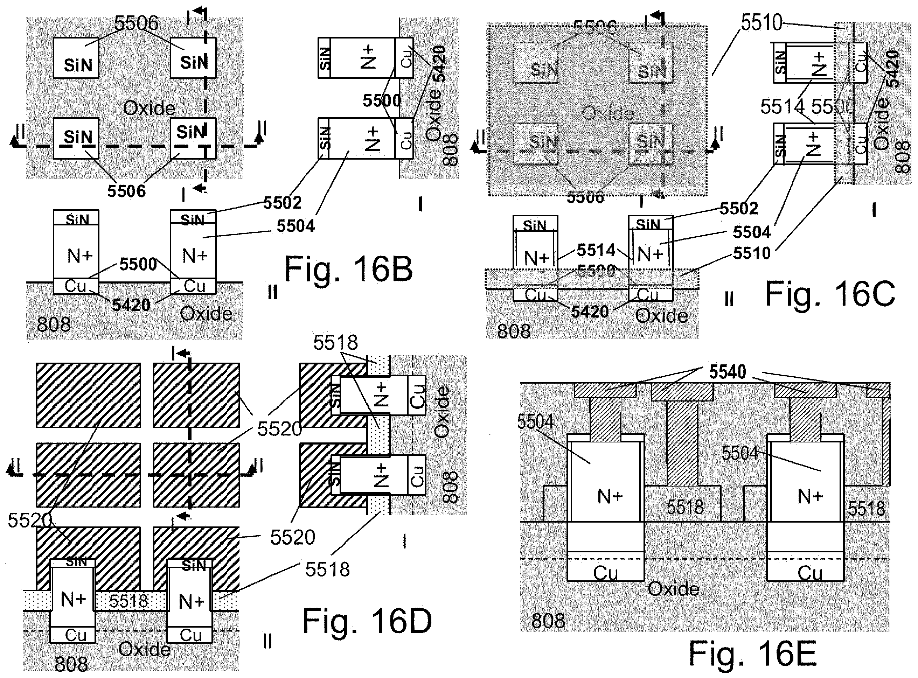

Additionally, a vertical gate all around junction-less transistor may be constructed as illustrated in Figures 15 and 16. The donor wafer preprocessed for the general layer transfer process is illustrated in Fig. 15. Fig. 15A is a drawing illustration of a pre-processed wafer used for a layer transfer. An N- wafer 5402 is processed to have a layer of N+ 5404, by ion implantation and activation, or an N+ epitaxial growth. Fig. 15B is a drawing illustration of the pre-processed wafer made ready for a conductive bond layer transfer by a deposition of a conductive barrier layer 5410 such as TiN or TaN and by an implant of an atomic species, such as H+, preparing the SmartCut cleaving plane 5412 in the lower part of the N+ 5404 region.

The acceptor wafer or house 808 is also prepared with an oxide pre-clean and deposition of a conductive barrier layer 5416 and Al and Ge layers to form a Ge-Al eutectic bond 5414 during a thermo-compressive wafer to wafer bonding as part of the layer-transfer-flow, thereby transferring the pre-processed single crystal silicon of Fig. 15B with an N+ layer 5404, on top of acceptor wafer or house 808, as illustrated in Fig. 15C. The N+ layer 5404 may be polished to remove damage from the cleaving procedure. Thus, a conductive path is made from the acceptor wafer or house 808 top metal layers 5420 to the N+ layer 5404 of the transferred donor wafer. Alternatively, the Al-Ge eutectic layer 5414 may be made with copper and a copper-to-copper or copper-to-barrier layer thermo-compressive bond is formed. Likewise, a conductive path from donor wafer to acceptor wafer or house 808 may be made by house top metal lines 5420 of copper with associated barrier metal thermo-compressively bonded with the copper layer 5410 directly, where a majority of the bonded surface is donor copper to house oxide bonds and the remainder of the surface is donor copper to acceptor wafer or house 808 copper and barrier metal bonds.

Figures 16A-16E are drawing illustrations of the formation of a vertical gate-all-around junction-less transistor utilizing the above preprocessed acceptor wafer or house 808 of Figure 15C. Fig. 16A illustrates the deposition of a CMP and plasma etch stop layer 5502, such as low temperature SiN, on top of the N+ layer 5504. For simplicity, the barrier clad Al-Ge eutectic layers 5410, 5414, and 5416 of Fig. 15C are represented by one illustrated layer 5500.

Similarly, Figures 16B-D are drawn as an orthographic projection to illustrate some process and topographical details. The junction-less transistor illustrated is square shaped when viewed from the top, but may be constructed in various rectangular shapes to provide different transistor channel thicknesses, widths, and gate control effects. In addition, the square shaped transistor illustrated may be intentionally formed as a circle when viewed from the top and hence form a vertical cylinder shape, or it may become that shape during processing subsequent to forming the vertical towers. The vertical transistor towers 5506 are mask defined and then plasma/Reactive-ion Etching (RIE) etched thru the Chemical Mechanical Polishing (CMP) stop layer 5502, N+ transistor channel layer 5504, the metal bonding layer 5500, and down to the acceptor wafer or house 808 oxide, and then the photoresist is removed, as illustrated in Figure 16B. This definition and etch now creates N+ transistor channel stacks that are electrically isolated from each other yet the bottom of N+ layer 5404 is electrically connected to the house metal layer 5420.

The area between the towers is then partially filled with oxide 5510 via a Spin On Glass (SPG) spin, low temperature cure, and etch back sequence as illustrated in Figure 16C. Alternatively, a low temperature CVD gap fill oxide may be deposited, then Chemically Mechanically Polished (CMP'ed) flat, and then selectively etched back to achieve the same shaped 5510 as shown in Figure 16C. Alternatively, this step may also be accomplished by a conformal low temperature oxide CVD deposition and etch back sequence, creating a spacer profile coverage of the N+ resistor tower layer 5504.

Next, the sidewall gate oxide 5514 is formed by a low temperature microwave oxidation technique, such as the TEL SPA (Tokyo Electron Limited Slot Plane Antenna) oxygen radical plasma, stripped by wet chemicals such as dilute HF, and grown again 5514 as illustrated in Figure 16C.

The gate electrode is then deposited, such as a P+ doped amorphous silicon layer 5518, then Chemically Mechanically Polished (CMP'ed) flat, and then selectively etched back to achieve the shape 5518 as shown in Figure 16D, and then the gate mask photoresist 5520 may be defined as illustrated in Figure 16D.

The gate layer 5518 is etched such that the gate layer is fully cleared from between the towers and then the photoresist is stripped as illustrated in Figure 16E.

The spaces between the towers are filled and the towers are covered with oxide by low temperature gap fill deposition, CMP, then another oxide deposition as illustrated in Figure 16E.

In Figure 16E, the contacts to the transistor channel tower N+ 5504 are masked and etched, and then the contacts 5518 to the gate electrode 5518 are masked and etch. The metal lines 5540 are mask defined and etched, filled with barrier metals and copper interconnect, and CMP'ed in a normal Dual Damascene interconnect scheme, thereby completing the contact via connections to the transistor channel tower N+ 5504 and the gate electrode 5518 as illustrated in Figure 16E.

This flow enables the formation of mono-crystalline silicon top vertical junction-less transistors that are connected to the underlying multi-metal layer semiconductor device without exposing the underlying devices and interconnect metals to high temperature. These junction-less transistors may be used as programming transistors on acceptor wafer or house 808 or as a pass transistor for logic or FPGA use, or for additional uses in a 3D semiconductor device.

A family of vertical devices can also be constructed as top transistors that are precisely aligned to the underlying pre-fabricated acceptor wafer or house 808. These vertical devices have implanted and annealed single crystal silicon layers in the transistor by utilizing the "SmartCut" layer transfer process that does not exceed the temperature limit of the underlying pre-fabricated structure. For example, vertical style MOSFET transistors, floating gate flash transistors, floating body DRAM, thyristor, bipolar, and Schottky gated JFET transistors, as well as memory devices, can be constructed. Junction-less transistors may also be constructed in a similar manner. The gates of the vertical transistors or resistors may be controlled by memory or logic elements such as MOSFET, DRAM, SRAM, floating flash, anti-fuse, floating body devices, etc. that are in layers above or below the vertical device, or in the same layer. As an example, a vertical gate-all-around n-MOSFET transistor construction is described below.

A planar n-channeljunction-less recessed channel array transistor (JLRCAT) suitable for a 3D IC may be constructed. The JLRCAT may provide an improved source and drain contact resistance, thereby allowing for lower channel doping, and the recessed channel may provide for more flexibility in the engineering of channel lengths and characteristics, and increased immunity from process variations.

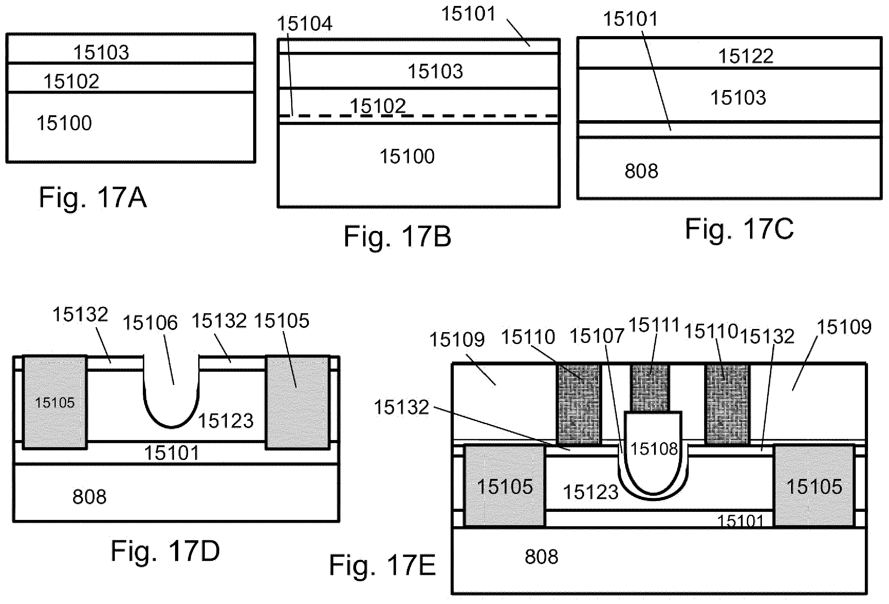

As illustrated in Fig. 17A, an N- substrate donor wafer 15100 may be processed to include wafer sized layers ofN+ doping 15102, and N- doping 15103 across the wafer. The N+ doped layer 15102 may be formed by ion implantation and thermal anneal. In addition, N- doped layer 15103 may have additional ion implantation and anneal processing to provide a different dopant level than N- substrate 15100. N- doped layer 15103 may also have graded N- doping to mitigate transistor performance issues, such as, for example, short channel effects, after the formation of the JLRCAT. The layer stack may alternatively be formed by successive epitaxially deposited doped silicon layers of N+ doping 15102 and N- doping 15103, or by a combination of epitaxy and implantation. Annealing of implants and doping may utilize optical annealing techniques or types of Rapid Thermal Anneal (RTA or spike).

As illustrated in Figure 17B, the top surface of donor wafer 15100 layers stack from Fig. 17A may be prepared for oxide wafer bonding with a deposition of an oxide to form oxide layer 15101 on top of N- doped layer 15103. A layer transfer demarcation plane (shown as dashed line) 15104 may be formed by hydrogen implantation, co-implantation such as hydrogen and helium, or other methods as previously described.

As illustrated in Figure 17C, both the donor wafer 15100 and acceptor substrate 808 may be prepared for wafer bonding as previously described and then low temperature (less than approximately 400°C) aligned and oxide to oxide bonded. Acceptor substrate 808, as described previously, may include, for example, transistors, circuitry, metal, such as, for example, aluminum or copper, interconnect wiring, and thru layer via metal interconnect strips or pads. The portion of the donor wafer 15100 and N+ doped layer 15102 that is below the layer transfer demarcation plane 15104 may be removed by cleaving or other processes as previously described, such as, for example, ion-cut or other methods. Oxide layer 15101, N- layer 15103, and N+ doped layer 15122 have been layer transferred to acceptor wafer 808. Now JLRCAT transistors may be formed with low temperature (less than approximately 400°C) processing and may be aligned to the acceptor wafer 808 alignment marks (not shown).

As illustrated in Fig. 17D, the transistor isolation regions 15105 may be formed by mask defining and then plasma/RIE etching N+ doped layer 15122, and N- layer 15103 to the top of oxide layer 15101 or into oxide layer 15101. Then a low-temperature gap fill oxide may be deposited and chemically mechanically polished, with the oxide remaining in isolation regions 15105. Then the recessed channel 15106 may be mask defined and etched thru N+ doped layer 15122 and partially into N- doped layer 15103. The recessed channel 15106 surfaces and edges may be smoothed by processes such as, for example, wet chemical, plasma/RIE etching, low temperature hydrogen plasma, or low temperature oxidation and strip techniques, to mitigate high field and other effects. These process steps may form isolation regions 15105, N+ source and drain regions 15132 and N- channel region 15123.

As illustrated in Fig. 17E, a gate dielectric 15107 may be formed and a gate metal material may be deposited. The gate dielectric 15107 may be an atomic layer deposited (ALD) gate dielectric that is paired with a work function specific gate metal in the industry standard high k metal gate process schemes described previously. Or the gate dielectric 15107 may be formed with a low temperature oxide deposition or low temperature microwave plasma oxidation of the silicon surfaces and then a gate metal material such as, for example, tungsten or aluminum may be deposited. Then the gate metal material may be chemically mechanically polished, and the gate area defined by masking and etching, thus forming gate electrode 15108.

A low temperature thick oxide 15109 may be deposited and planarized, and source, gate, and drain contacts, and thru layer via (not shown) openings may be masked and etched, thereby preparing the transistors to be connected via metallization. Thus gate contact 15111 connects to gate electrode 15108, and source & drain contacts 15110 connect to N+ source and drain regions 15132. Thru layer vias (not shown) may be formed to connect to the acceptor substrate connect strips (not shown) as previously described.

The junction-less transistor channel may be constructed with even, graded, or discrete layers of doping. The channel may be constructed with materials other than doped mono-crystalline silicon, such as poly-crystalline silicon, or other semi-conducting, insulating, or conducting material, such as graphene or other graphitic material, and may be in combination with other layers of similar or different material. For example, the center of the channel may comprise a layer of oxide, or of lightly doped silicon, and the edges more heavily doped single crystal silicon. This may enhance the gate control effectiveness for the off state of the resistor, and may also increase the on-current due to strain effects on the other layer or layers in the channel. Strain techniques may also be employed from covering and insulator material above, below, and surrounding the transistor channel and gate. Lattice modifiers may also be employed to strain the silicon, such as an embedded SiGe implantation and anneal. The cross section of the transistor channel may be rectangular, circular, or oval shaped, to enhance the gate control of the channel. Alternatively, to optimize the mobility of the P-channel junction-less transistor in the 3D layer transfer method, the donor wafer may be rotated 90 degrees with respect to the acceptor wafer prior to bonding to facilitate the creation of the P-channel in the <110> silicon plane direction.

Alternatively, the wafer that becomes the bottom wafer in Figure 15C may be constructed wherein the N+ layer 5504 may be formed with heavily doped polysilicon a. The bottom wafer N+ silicon or polysilicon layer 5504 will eventually become the top-gate of the junction-less transistor.

Persons of ordinary skill in the art will appreciate that the illustrations in Figs.17A through 17E are exemplary only and are not drawn to scale. Such skilled persons will further appreciate that many variations are possible such as, for example, a p-channel JLRCAT may be formed with changing the types of dopings appropriately. Moreover, the substrate 15100 may be p type as well as the n type described above. Further, N- doped layer 15103 may include multiple layers of different doping concentrations and gradients to fine tune the eventual JLRCAT channel for electrical performance and reliability characteristics, such as, for example, off-state leakage current and on-state current. Furthermore, isolation regions 15105 may be formed by a hard mask defined process flow, wherein a hard mask stack, such as, for example, silicon oxide and silicon nitride layers, or silicon oxide and amorphous carbon layers. Moreover, CMOS JLRCATs may be constructed with n-JLRCATs in one mono-crystalline silicon layer and p-JLRCATs in a second mono-crystalline layer, which may include different crystalline orientations of the mono-crystalline silicon layers, such as for example, <100>, <111> or <551>, and may include different contact silicides for optimum contact resistance to p or n type source, drains, and gates. Furthermore, a back-gate or double gate structure may be formed for the JLRCAT and may utilize techniques described elsewhere in this document. Many other modifications within the scope of the invention will suggest themselves to such skilled persons after reading this specification. Thus the invention is to be limited only by the appended claims.

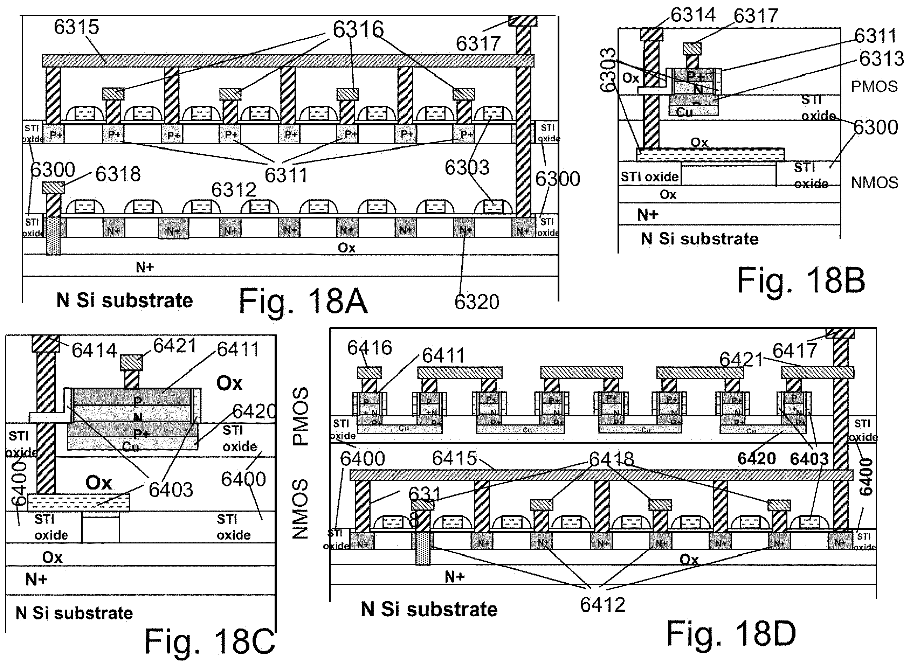

The topside view of the 3D NAND-8 cell, with no metal shown and with horizontal NMOS and PMOS devices, is illustrated in Y cross sectional view is illustrated in Figure 18A. The NAND-8 cell with vertical PMOS and horizontal NMOS devices are shown in 18B for the X cross section view. The same reference numbers are used for analogous structures in the embodiment shown in Figs. 18A through 18D. The eight PMOS sources 6311 are tied together in the PMOS silicon layer and to the V+ supply metal 6316 in the PMOS metal 1 layer thru P+ to Metal contacts. The NMOS A drain and the PMOS A drain are tied 6313 together with a thru P+ to N+ contact 6317 and to the output Y supply metal 6315 in PMOS metal 2, and also connected to substantially all of the PMOS drain contacts thru PMOS metal 1 6315. Input A on PMOS metal 2 6314 is tied 6303 to both the PMOS A gate and the NMOS A gate with a PMOS gate on STI to NMOS gate on STI contact 6314. Substantially all the other inputs are tied to P and N gates in similar fashion. The NMOS A source and the NMOS B drain are tied together 6320 in the NMOS silicon layer. The NMOS H source 6232 is tied connected to the ground line 6318 by a contact to NMOS metal 1 and to the back plane N+ ground layer. The transistor isolation oxides 6300 are illustrated.

A compact 3D CMOS 8 Input NOR may be constructed as illustrated in Figures 18C thru 18D. The PMOS transistor source 6411 may be tied to V+ supply. The NMOS drains are tied together 6413 and to the drain of PMOS A and to Output Y. Inputs A to H are tied to one PMOS gate and one NMOS gate. Input A is tied 6403 to the PMOS A gate and NMOS A gate. The NMOS sources are substantially all tied 6412 to ground. The PMOS drain is tied 6420 to the next PMOS source in the stack, PMOS, and repeated so forth. The structure built in 3D described below will take advantage of these connections in the 3rd dimension.

The view of the 3D NOR-8 cell, with vertical PMOS and horizontal NMOS devices are shown in Figures 18D for the X cross section view, and 18D for the Y cross sectional view. The PMOS source 6411 is tied to the V+ supply metal 6416 in the PMOS metal 1 layer thru a P+ to Metal contact. The PMOS drain is tied 6420 to PMOS source in the PMOS silicon layer. The NMOS sources 6412 are substantially all tied to ground by N+ to NMOS metal-1 contacts to metal lines 6418 and to the backplane N+ ground layer in the N- substrate. Input A on PMOS metal-2 is tied to both PMOS and NMOS gates 6403 with a gate on STI to gate on STI contact 6414. The NMOS drains are substantially all tied together with NMOS metal-2 6415 to the NMOS A drain and PMOS A drain 6413 by the P+ to N+ to PMOS metal-2 contact 6417, which is tied to output Y. Figure 18D illustrates the use of vertical PMOS transistors to compactly tie the stack sources and drain, and make a very compact area cell. The transistor isolation oxides 6400 are illustrated.

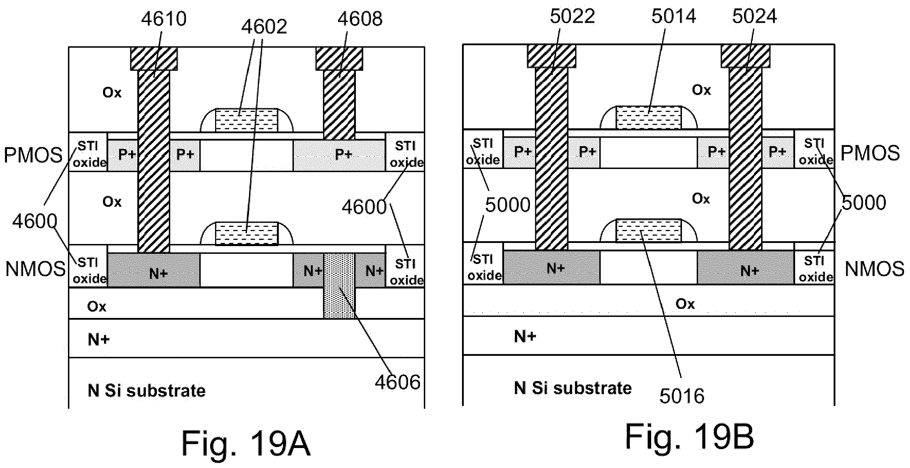

The above process flow may be used to construct a compact 3D CMOS inverter cell example as illustrated in Figures 19A. In Figure 19A the STI (shallow trench isolation) 4600 for both NMOS and PMOS is drawn coincident and the PMOS is on top of the NMOS.

Y direction cross sectional view is illustrated in Figure 19A. The NMOS and PMOS gates 4602 are drawn coincident and stacked,

The above process flow may be used to construct a compact 3D CMOS transmission cell example as illustrated in Figures 19B. The STI (shallow trench isolation) 5000 for both NMOS and PMOS may be drawn coincident on the top and sides. The Y cross sectional view is illustrated in Fig. 19B. The PMOS gate 5014 may be drawn coincident and stacked with the NMOS gate 5016. The NMOS and PMOS source shared contacts 5022 make the shared connection for the input. The NMOS and PMOS drain shared contacts 5024 make the shared connection for the output.

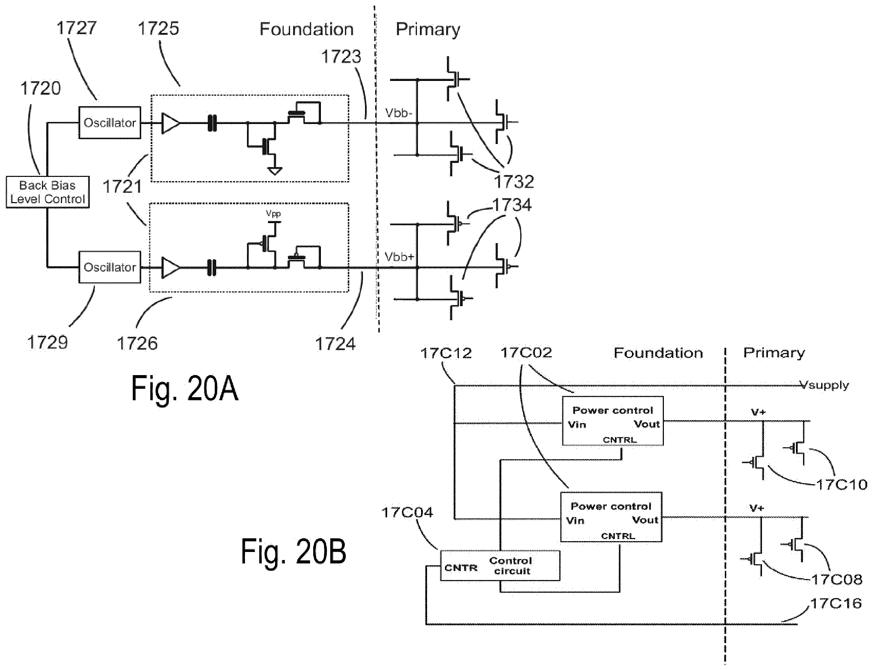

Fig. 20A is a drawing illustration of back bias circuits. A back bias level control circuit 1720 is controlling the oscillators 1727 and 1729 to drive the voltage generators 1721. The negative voltage generator 1725 will generate the desired negative bias which will be connected to the primary circuit by connection 1723 to back bias the N-channel Metal-Oxide-Semiconductor (NMOS) transistors 1732 on the primary silicon 1404. The positive voltage generator 1726 will generate the desired negative bias which will be connected to the primary circuit by connection 1724 to back bias the P-channel Metal-Oxide-Semiconductor (PMOS) transistors 1724 on the primary silicon 1404. The setting of the proper back bias level per zone will be done in the initiation phase. It could be done by using external tester and controller or by on-chip self test circuitry. Preferably a non volatile memory will be used to store the per zone back bias voltage level so the device could be properly initialized at power up. Alternatively a dynamic scheme could be used where different back bias level(s) are used in different operating modes of the device. Having the back bias circuitry in the foundation allows better utilization of the primary device silicon resources and less distortion for the logic operation on the primary device.

Fig. 20B illustrates an alternative circuit function that may fit well in the "Foundation." In many IC designs it is desired to integrate power control to reduce either voltage to sections of the device or to totally power off these sections when those sections are not needed or in an almost 'sleep' mode. In general such power control is best done with higher voltage transistors. Accordingly a power control circuit cell 17C02 may be constructed in the Foundation. Such power control 17C02 may have its own higher voltage supply and control or regulate supply voltage for sections 17C10 and 17C08 in the "Primary" device. The control may come from the primary device 17C16 and be managed by control circuit 17C04 in the Foundation

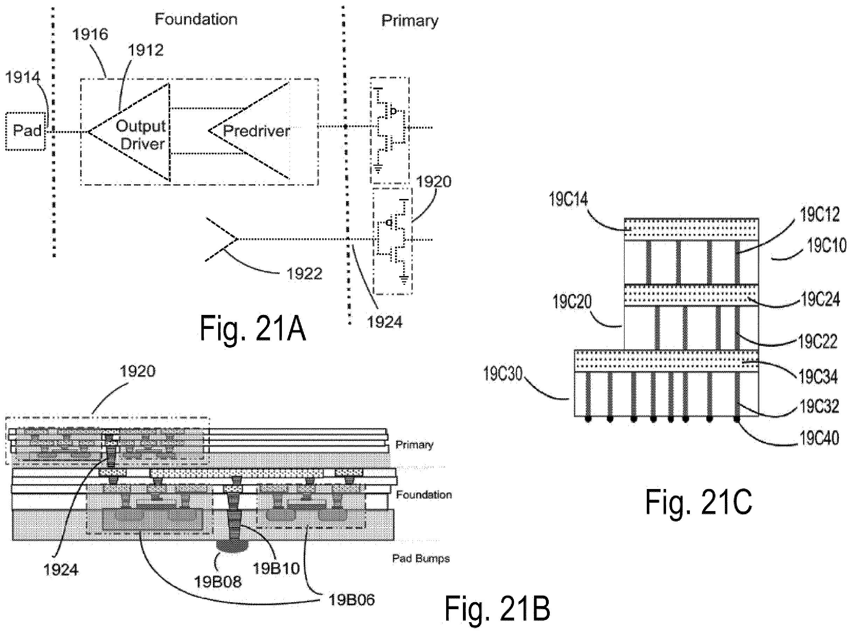

Fig. 21A is a drawing illustration of an underlying I/O. The foundation could also be preprocessed to carry the I/O circuits or part of it, such as the relatively large transistors of the output drive 1912. Additionally TSV in the foundation could be used to bring the I/O connection 1914 all the way to the back side of the foundation. Fig. 21B is a drawing illustration of a side "cut" of an integrated device according to an embodiment of the present invention. The Output Driver is illustrated by PMOS and NMOS output transistors 19B06 coupled through TSV 19B10 to connect to a backside pad or pad bump 19B08. The connection material used in the foundation can be selected to withstand the temperature of the following process constructing the full device as illustrated in Fig. 8A, such as tungsten. The foundation could also carry the input protection circuit 1916 connecting the pad 19B08 to the input logic 1920 in the primary circuits.

An additional embodiment of the present invention may be to use TSVs in the foundation such as TSV 19B10 to connect between wafers to form 3D Integrated Systems. In general each TSV takes a relatively large area, typically a few square microns. When the need is for many TSVs, the overall cost of the area for these TSVs might be high if the use of that area for high density transistors is precluded. Pre-processing these TSVs on the donor wafer on a relatively older process line will significantly reduce the effective costs of the 3D TSV connections. The connection 1924 to the primary silicon circuitry 1920 could be then made at the minimum contact size of few tens of square nanometers, which is two orders of magnitude lower than the few square microns needed by the TSVs. Those of ordinary skill in the art will appreciate that Fig. 21B is for illustration only and is not drawn to scale. Such skilled persons will understand there are many alternative embodiments and component arrangements that could be constructed using the inventive principles shown and that Fig. 21B is not limiting in any way.

Figure 21C demonstrates a 3D system comprising three dice 19C10, 19C20 and 19C30 coupled together with TSVs 19C12, 19C22 and 19C32 similar to TSV 19B10 as described in association with Fig. 21A. The stack of three dice utilize TSV in the Foundations 19C12, 19C22, and 19C32 for the 3D interconnect may allow for minimum effect or silicon area loss of the Primary silicon 19C14, 19C24 and 19C34 connected to their respective Foundations with minimum size via connections. The three die stacks may be connected to a PC Board using bumps 19C40 connected to the bottom die TSVs 19C32. Those of ordinary skill in the art will appreciate that Fig. 21C is for illustration only and is not drawn to scale. Such skilled persons will understand there are many alternative embodiments and component arrangements that could be constructed using the inventive principles shown and that Fig. 21C is not limiting in any way. For example, a die stack could be placed in a package using flip chip bonding or the bumps 19C40 could be replaced with bond pads and the part flipped over and bonded in a conventional package with bond wires.

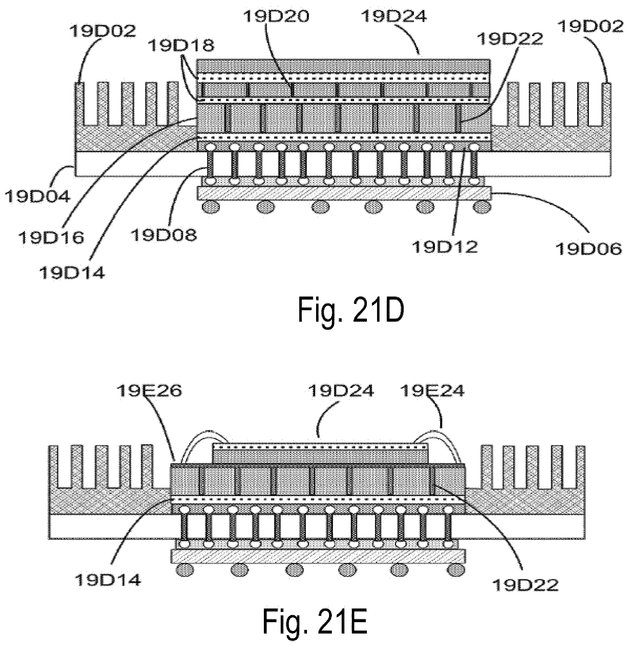

Fig. 21D illustrates a 3D IC processor and DRAM system. A well known problem in the computing industry is known as the "memory wall" and relates to the speed the processor can access the DRAM. The prior art proposed solution was to connect a DRAM stack using TSV directly on top of the processor and use a heat spreader attached to the processor back to remove the processor heat. But in order to do so, a special via needs to go "through DRAM" so that the processor I/Os and power could be connected. Having many processor-related 'through-DRAM vias" leads to a few severe disadvantages. First, it reduces the usable silicon area of the DRAM by a few percent. Second, it increases the power overhead by a few percent. Third, it requires that the DRAM design be coordinated with the processor design which is very commercially challenging. The embodiment of Fig. 21D illustrates one solution to mitigate the above mentioned disadvantages by having a foundation with TSVs as illustrated in Fig. 21B and 21C. The use of the foundation and primary structure may enable the connections of the processor without going through the DRAM.

In Fig. 21D the processor I/Os and power may be coupled from the face-down microprocessor active area 19D14 -the primary layer, by vias 19D08 through heat spreader substrate 19D04 to an interposer 19D06. A heat spreader 19D12, the heat spreader substrate19D04, and heat sink 19D02 are used to spread the heat generated on the processor active area 19D14. TSVs 19D22 through the Foundation 19D16 are used for the connection of the DRAM stack 19D24. The DRAM stack comprises multiple thinned DRAM 19D18 interconnected by TSV 19D20. Accordingly the DRAM stack does not need to pass through the processor I/O and power planes and could be designed and produced independent of the processor design and layout. The DRAM chip 19D18 that is closest to the Foundation 19D16 may be designed to connect to the Foundation TSVs 19D22, or a separate Re-Distribution Layer (or RDL, not shown) may be added in between, or the Foundation 19D16 could serve that function with preprocessed high temperature interconnect layers, such as Tungsten, as described previously. And the processor's active area is not compromised by having TSVs through it as those are done in the Foundation 19D16.

Alternatively the Foundation vias 19D22 could be used to pass the processor I/O and power to the substrate 19D04 and to the interposer 19D06 while the DRAM stack would be coupled directly to the processor active area 19D14. Persons of ordinary skill in the art will appreciate that many more combinations are possible within the scope of the disclosed present invention.

Fig. 21E illustrates another embodiment of the present invention wherein the DRAM stack 19D24 may be coupled by wire bonds 19E24 to an RDL (Re-Distribution Layer) 19E26 that couples the DRAM to the Foundation vias 19D22, and thus couples them to the face-down processor 19D14.

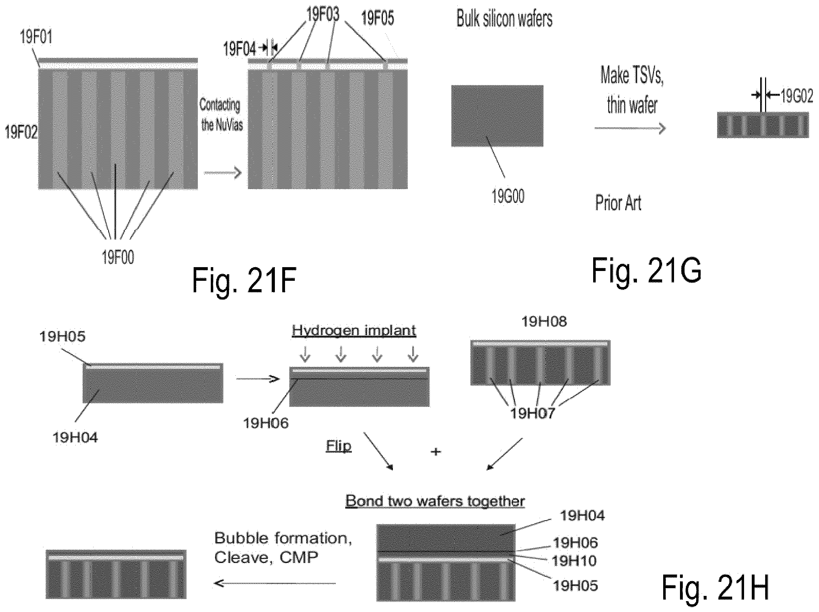

In yet another embodiment, custom SOI wafers are used where NuVias 19F00 may be processed by the wafer supplier. NuVias 19F00 may be conventional TSVs that may be 1 micron or larger in diameter and may be preprocessed by an SOI wafer vendor. This is illustrated in Fig. 21F with handle wafer 19F02 and Buried Oxide BOX 19F01. The handle wafer 19F02 may typically be many hundreds of microns thick, and the BOX 19F01 may typically be a few hundred nanometers thick. The Integrated Device Manufacturer (IDM) or foundry then processes NuContacts 19F03 to connect to the NuVias 19F00. NuContacts may be conventionally dimensioned contacts etched thru the thin silicon 19F05 and the BOX 19F01 of the SOI and filled with metal. The NuContact diameter DNuContact 19F04, in Fig. 21F may then be processed into the tens of nanometer range. The prior art of construction with bulk silicon wafers 19G00 as illustrated in Fig. 21G typically has a TSV diameter, DTSV prior art 19G02, in the micron range. The reduced dimension of NuContact DNuContact 19F04 in Fig. 21F may have important implications for semiconductor designers. The use of NuContacts may provide reduced die size penalty of through-silicon connections, reduced handling of very thin silicon wafers, and reduced design complexity. The arrangement of TSVs in custom SOI wafers can be based on a high-volume integrated device manufacturer (IDM) or foundry's request, or be based on a commonly agreed industry standard.

A process flow as illustrated in Fig. 21H may be utilized to manufacture these custom SOI wafers. Such a flow may be used by a wafer supplier. A silicon donor wafer 19H04 is taken and its surface 19H05 may be oxidized. An atomic species, such as, for example, hydrogen, may then be implanted at a certain depth 19H06. Oxide-to-oxide bonding as described in other embodiments may then be used to bond this wafer with an acceptor wafer 19H08 having pre-processed NuVias 19H07. The NuVias 19H07 may be constructed with a conductive material, such as tungsten or doped silicon, which can withstand high-temperature processing. An insulating barrier, such as, for example, silicon oxide, may be utilized to electrically isolate the NuVia 19H07 from the silicon of the acceptor wafer 19H08. Alternatively, the wafer supplier may construct NuVias 19H07 with silicon oxide. The integrated device manufacturer or foundry etches out this oxide after the high-temperature (more than 400°C) transistor fabrication is complete and may replace this oxide with a metal such as copper or aluminum. This process may allow a low-melting point, but highly conductive metal, like copper to be used. Following the bonding, a portion 19H10 of the donor silicon wafer 19H04 may be cleaved at 19H06 and then chemically mechanically polished as described in other embodiments.

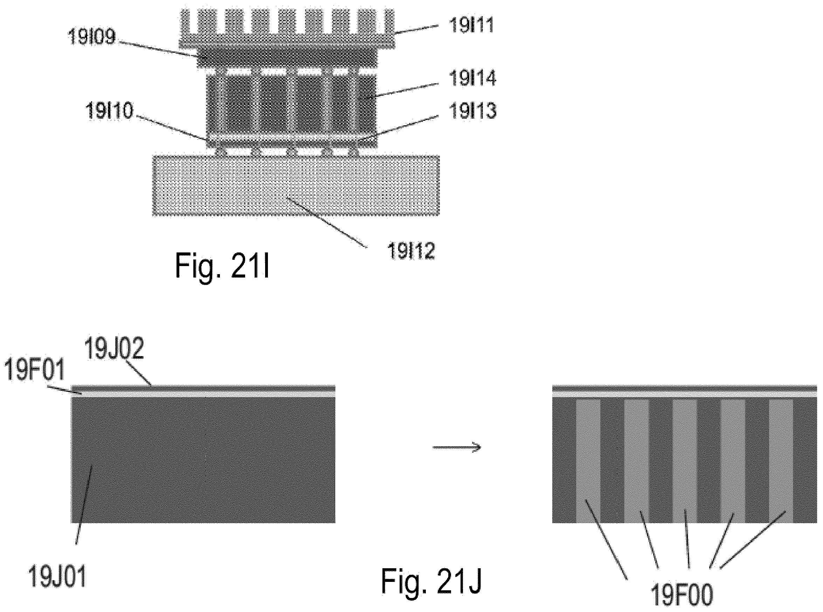

Fig. 21J depicts another technique to manufacture custom SOI wafers. A standard SOI wafer with substrate 19J01, box 19F01, and top silicon layer 19J02 may be taken and NuVias 19F00 may be formed from the back-side up to the oxide layer. This technique might have a thicker buried oxide 19F01 than a standard SOI process.

Fig. 21I depicts how a custom SOI wafer may be used for 3D stacking of a processor 19109 and a DRAM 19I10. In this configuration, a processor's power distribution and I/O connections have to pass from the substrate 19I12, go through the DRAM 19I10 and then connect onto the processor 19109. The above described technique in Fig. 21F may result in a small contact area on the DRAM active silicon, which is very convenient for this processor-DRAM stacking application. The transistor area lost on the DRAM die due to the through-silicon connection 19I13 and 19I14 is very small due to the tens of nanometer diameter of NuContact 19113 in the active DRAM silicon. It is difficult to design a DRAM when large areas in its center are blocked by large through-silicon connections. Having small size through-silicon connections may help tackle this issue. Persons of ordinary skill in the art will appreciate that this technique may be applied to building processor-SRAM stacks, processor-flash memory stacks, processor-graphics-memory stacks, any combination of the above, and any other combination of related integrated circuits such as, for example, SRAM-based programmable logic devices and their associated configuration ROM/PROM/EPROM/EEPROM devices, ASICs and power regulators, microcontrollers and analog functions, etc. Additionally, the silicon on insulator (SOI) may be a material such as polysilicon, GaAs, GaN, etc. on an insulator. Such skilled persons will appreciate that the applications of NuVia and NuContact technology are extremely general and the scope of the present invention is to be limited only by the appended claims.

Accordingly a CMOS circuit may be constructed where the various circuit cells are built on two silicon layers achieving a smaller circuit area and shorter intra and inter transistor interconnects. As interconnects become dominating for power and speed, packing circuits in a smaller area would result in a lower power and faster speed end device.

Persons of ordinary skill in the art will appreciate that a number of different process flows have been described with exemplary logic gates and memory bit cells used as representative circuits. Such skilled persons will further appreciate that whichever flow is chosen for an individual design, a library of all the logic functions for use in the design may be created so that the cells may easily be reused either within that individual design or in subsequent ones employing the same flow. Such skilled persons will also appreciate that many different design styles may be used for a given design. For example, a library of logic cells could be built in a manner that has uniform height called standard cells as is well known in the art. Alternatively, a library could be created for use in long continuous strips of transistors called a gated array which is also known in the art. In another alternative embodiment, a library of cells could be created for use in a hand crafted or custom design as is well known in the art. For example, in yet another alternative embodiment, any combination of libraries of logic cells tailored to these design approaches can be used in a particular design as a matter of design choice, the libraries chosen may employ the same process flow if they are to be used on the same layers of a 3D IC. Different flows may be used on different levels of a 3D IC, and one or more libraries of cells appropriate for each respective level may be used in a single design.

The disclosure presents two forms of 3D IC system, first by using TSV and second by using the method referred to herein as the 'Attic' described in, for example, Figs. 12A to Fig.17E. Those two methods could even work together as a devices could have multiple layers of mono- or poly-crystalline silicon produced using layer transfer or deposits and the techniques referred to herein as the 'Foundation' and the 'Attic' and then connected together using TSV. The most significant difference is that prior TSVs are associated with a relatively large misalignment (approximately 1 micron) and limited connections (TSV) per mm sq. of approximately 10,000 for a connected fully fabricated device while the disclosed 'smart-cut' - layer transferred techniques allow 3D structures with a very small misalignment (<10 nm) and high number of connections (vias) per mm sq. of approximately 100,000,000, since they are produced in an integrated fabrication flow. An advantage of 3D using TSV is the ability to test each device before integrating it and utilize the Known Good Die (KGD) in the 3D stack or system. This is very helpful to provide good yield and reasonable costs of the 3D Integrated System.

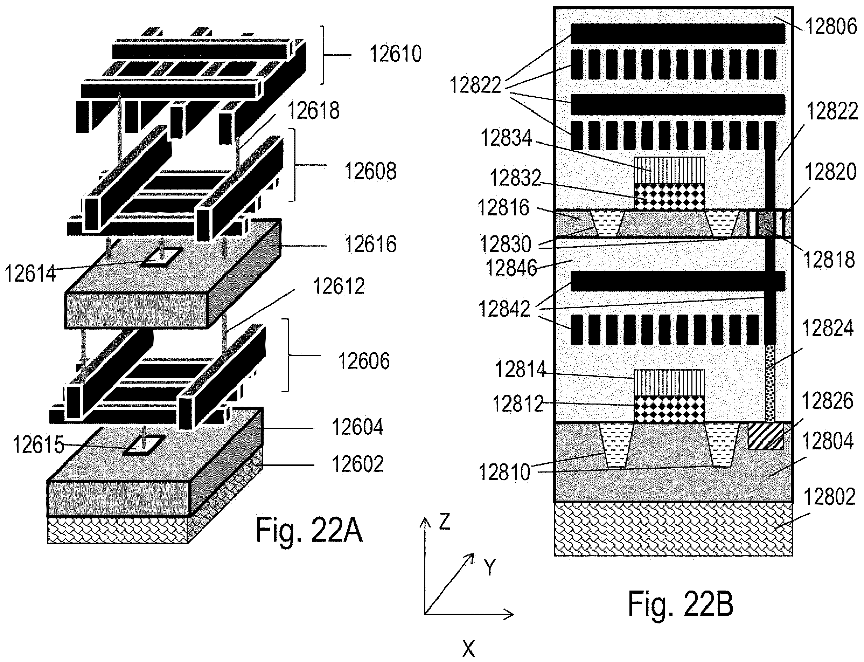

Figs. 22A and 22B illustrate how the power or ground distribution network of a 3D integrated circuit could assist heat removal. Fig. 22A illustrates an exemplary power distribution network or structure of the 3D integrated circuit. The 3D integrated circuit, could, for example, be constructed with two silicon layers 12604 and 12616. The heat removal apparatus 12602 could include a heat spreader and a heat sink. The power distribution network or structure could consist of a global power grid 12610 that takes the supply voltage (denoted as VDD) from power pads and transfers it to local power grids 12608 and 12606, which then transfer the supply voltage to logic cells or gates such as 12614 and 12615. Vias 12618 and 12612, such as the previously described TSV or TLV, could be used to transfer the supply voltage from the global power grid 12610 to local power grids 12608 and 12606. The 3D integrated circuit could have a similar distribution networks, such as for ground and other supply voltages, as well. Typically, many contacts are made between the supply and ground distribution networks and silicon layer 12604. Due to this, there could exist a low thermal resistance between the power/ground distribution network and the heat removal apparatus 12602. Since power/ground distribution networks are typically constructed of conductive metals and could have low effective electrical resistance, they could have a low thermal resistance as well. Each logic cell or gate on the 3D integrated circuit (such as, for example 12614) is typically connected to VDD and ground, and therefore could have contacts to the power and ground distribution network. These contacts could help transfer heat efficiently (i.e. with low thermal resistance) from each logic cell or gate on the 3D integrated circuit (such as, for example 12614) to the heat removal apparatus 12602 through the power/ground distribution network and the silicon layer 12604.

Fig. 22B describes an embodiment of this present invention, where the concept of thermal contacts is described. Two mono-crystalline silicon layers, 12804 and 12816 may have transistors. Silicon layer 12816 could be thinned down from its original thickness, and its thickness could be in the range of approximately 3nm to approximately 1um. Mono-crystalline silicon layer 12804 could have STI regions 12810, gate dielectric regions 12812, gate electrode regions 12814 and several other regions required for transistors (not shown). Mono-crystalline silicon layer 12816 could have STI regions 12830, gate dielectric regions 12832, gate electrode regions 12834 and several other regions required for transistors (not shown). Heat removal apparatus 12802 may include, for example, heat spreaders and heat sinks. In the example shown in Fig. 22B, mono-crystalline silicon layer 12804 is closer to the heat removal apparatus 12802 than other mono-crystalline silicon layers such as 12816. Dielectric regions 12806 and 12846 could be used to insulate wiring regions such as 12822 and 12842 respectively. Through-layer vias for power delivery 12818 and their associated dielectric regions 12820 are shown. A thermal contact 12824 can be used that connects the local power distribution network or structure, which may include wiring layers 12842 used for transistors in the silicon layer 12804, to the silicon layer 12804. Thermal junction region 12826 can be either a doped or undoped region of silicon. The thermal contact such as 12824 can be preferably placed close to the corresponding through-layer via for power delivery 12818; this helps transfer heat efficiently from the through-layer via for power delivery 12818 to thermal junction region 12826 and silicon layer 12804 and ultimately to the heat removal apparatus 12802. For example, the thermal contact 12824 could be located within approximately 2um distance of the through-layer via for power delivery 12818 in the X-Y plane (the through-layer via direction is considered the Z plane in Fig. 22B). While the thermal contact such as 12824 is described above as being between the power distribution network or structure and the silicon layer closest to the heat removal apparatus, it could also be between the ground distribution network and the silicon layer closest to the heat sink. Furthermore, more than one thermal contact 12824 can be placed close to the through-layer via for power delivery 12818. These thermal contacts can improve heat transfer from transistors located in higher layers of silicon such as 12816 to the heat removal apparatus 12802. While mono-crystalline silicon has been mentioned as the transistor material in this paragraph, other options are possible including, for example, poly-crystalline silicon, mono-crystalline germanium, mono-crystalline III-V semiconductors, graphene, and various other semiconductor materials with which devices, such as transistors, may be constructed within.

Some embodiments of the invention may include alternative techniques to build IC (Integrated Circuit) devices including techniques and methods to construct 3D IC systems. Some embodiments of the invention may enable device solutions with far less power consumption than prior art. These device solutions could be very useful for the growing application of mobile electronic devices and mobile systems such as mobile phones, smart phone, cameras and the like. For example, incorporating the 3D IC semiconductor devices according to some embodiments of the invention within these mobile electronic devices and mobile systems could provide superior mobile units that could operate much more efficiently and for a much longer time than with prior art technology. The 3D IC techniques and the methods to build devices according to various embodiments of the invention could empower the mobile smart system to win in the market place, as they provide unique advantages for aspects that are very important for 'smart' mobile devices, such as, low size and volume, low power, versatile technologies and feature integration, low cost, self-repair, high memory density, high performance. These advantages would not be achieved without the use of some embodiment of the invention.

3D ICs according to some embodiments of the invention could also enable electronic and semiconductor devices with much a higher performance due to the shorter interconnect as well as semiconductor devices with far more complexity via multiple levels of logic and providing the ability to repair or use redundancy. The achievable complexity of the semiconductor devices according to some embodiments of the invention could far exceed what was practical with the prior art technology. These advantages could lead to more powerful computer systems and improved systems that have embedded computers.

It will also be appreciated by persons of ordinary skill in the art that the invention is not limited to what has been particularly shown and described hereinabove. Rather, the scope of the invention includes both combinations and sub-combinations of the various features described hereinabove as well as modifications and variations which would occur to such skilled persons upon reading the foregoing description. Thus the invention is to be limited only by the appended claims.

Embodiments may be provided in accordance with the following numbered clauses:
1. A method for formation of a semiconductor device including a first wafer comprising a first single crystal layer comprising first transistors and first alignment mark, the method comprising: implanting to form a doped layer within a second wafer; forming a second mono-crystalline layer on top of said first wafer by transferring at least a portion of said doped layer using layer transfer step, and completing the formation of second transistors on said second mono-crystalline layer comprising a step of forming a gate dielectric followed by second transistors gate formation step, wherein said second transistors are horizontally oriented.
2. A method according to clause 1, comprising providing at least one metal layer overlying said first single crystal silicon layer, wherein said at least one metal layer comprises copper or aluminum; and provides interconnection for said first transistors.
3. A method according to clause 1, comprising forming a low power mobile system by integrating in said semiconductor device.
4. A method according to clause 1, comprising performing a lithography step followed by a processing step affecting the formation of said first transistors and also said second transistors.
5. A method according to clause 1, wherein at least one of said second transistors comprises drain and source formed in said second mono-crystalline layer and wherein said gate formation step comprises forming side gate.
6. A method according to clause 1, wherein at least one of said second transistors is a junction- less transistor.
7. A method according to clause 1, wherein at least one of said second transistors is a recessed-channel transistor (RCAT).
8. A method according to clause 1, wherein said completing the formation of second transistors comprises gate replacement step to at least one of said second transistors.
9. A method according to clause 1, wherein said completing the formation of second transistors comprises an optical annealing step to at least one of said second transistors.
10. A method according to clause 1, wherein at least one of said second transistors is a p-type transistor and at least one of said second transistors is an n-type transistor.
11. A method according to clause 1, wherein at least one of said second transistors is a thin-side-up transistor.
12. A method according to clause 1, wherein said second wafer comprises second alignment mark, and comprising a lithography step wherein its alignment comprises aligning in a first direction according to said first alignment mark and in the perpendicular direction according to said second alignment mark.
13. A method according to clause 1, wherein said second wafer comprises second alignment mark, and comprising a lithography step wherein its alignment comprises aligning based on the distance between said first alignment mark and said second alignment mark.
14. A method according to clause 1, comprising a follow on step of etching some of said second transistors to form custom function.
15. A method according to clause 1, comprising: first logic circuit comprising said first transistor; and second logic circuit comprising said second transistors, wherein said second logic circuit overlay said first logic circuit, and performing a step of testing said device and a follow on step of replacing: said first logic circuits by said second logic circuits, or said second logic circuits by said first logic circuits.
16. A method according to clause 1, comprising: first logic circuit comprising said first transistor; and second logic circuit comprising said second transistors, wherein said second logic circuit overlay said first logic circuit, and performing a step of replacing: said first logic circuits by said second logic circuits, or replacing said second logic circuits by said first logic circuits.
17. A method according to clause 1, wherein the source and drain of said second transistors are horizontally oriented.
18. A method according to clause 1, wherein at least one of said second transistors has a double gate.
19. A method according to clause 1, wherein at least one of said second transistors is a Finfet type transistor.
20. A method according to clause 1, wherein said completing the formation of second transistors comprises a step of short wavelength anneal.
21. A method according to clause 1, wherein at least one of said second transistors is Dopant Segregated Schottky (DSS-Schottky) transistor.
22. A method according to clause 1, further comprising: replacing a signal generated by said first transistors by a signal generated by said second transistor, or replacing a signal generated by said second transistors by a signal generated by said first transistors, in order to repair the operation of said device.
23. A method according to clause 1, comprising a step of forming thermal contact to said second mono-crystalline layer, wherein said thermal contact is designed to conduct heat but to not conduct electricity.
24. A method according to clause 1, comprising a step of partitioning a logic design to a first portion to be constructed using said first transistors and second portion to be constructed by said second transistors wherein said step of partitioning is done so the lithography tool required for the construction of said second portion costs at least 20% less than the lithography tool required for the construction of said first portion.
25. A method according to clause 1, comprising using said second transistors to form a logic cell, wherein said logic cell comprises a thermal path to remove heat.
26. A method according to clause 25, wherein said thermal path form a heat removal path from said logic cell to power or ground bus.
27. A method according to clause 1, wherein at least one of said second transistors comprises a thermal path that provides thermal connection to the power bus and said thermal path is not used to power said at least one of said second transistors.
28. A method according to clause 1, comprising a step of depositing at least one electrical isolation region between at least two of said second transistors, wherein said electrical isolation region is designed to conduct heat.
29. A method according to clause 1, comprising a step of depositing a heat spreading layer between said second mono-crystalline layer and said first crystallized layer.
30. A method according to clause 1, comprising a step of forming at least one thermally conductive path between the power bus and an isolation layer between two of said second transistors.
31. A method according to clause 1, wherein said layer transfer comprises a prior etch step for the formation of an etch stop indicator.
32. A method according to clause 1, wherein said second mono-crystalline layer comprises an electrical connection path connecting at least four of said second transistors.
33. A method according to clause 1, comprises memory array comprising said second transistors, wherein said memory array comprises at least one source line embedded in said second mono-crystalline layer.
34. A method according to clause 1, comprises memory array comprising said second transistors, comprising a step of forming peripheral circuits to control said memory array using third transistors, wherein said third transistors formation comprises a third crystallized layer which is overlaying said second mono-crystalline layer.
35. A method according to clause 1, comprises memory array comprising said second transistors, wherein said memory array is a floating body DRAM array.
36. A method according to clause 1, comprising a step implementing logic design on said device, wherein said step of implementing comprises a synthesis step utilizing at least two libraries, wherein one of said libraries utilized more aggressive design rules than the other.
37. A method according to clause 1, comprising a step of designing the power busses based on heat removal criteria.
38. A method according to clause 1, comprising a testing step wherein said testing is done without making physical contact with said device.
39. A method according to clause 1, wherein said layer transfer step comprise carrier wafer.
40. A method according to clause 1, comprising at, least three metal layers between said first single crystal layer and said second mono-crystalline layer, wherein said at least three metal layers comprises metal three overlying metal two overlying metal one, and wherein metal two pitch is lower than said first metal pitch and said third metal pitch.
41. A method according to clause 1, wherein said step of implant to form a doped layer within a second wafer, comprises activation at high temperature.
42. A method for formation of semiconductor device comprising: a first wafer comprising first mono-crystalline layer comprising first transistors, and comprising a step of implant to form second transistors within a second mono-crystalline layer, and transferring a second mono-crystalline layer on top of said first mono-crystalline layer wherein said method comprises the use of at least ten masks, each with its own unique patterns, and wherein said method is used for formation of at least two devices which are substantially different by the amount of logic, memory or Input-Output cells they have, wherein each of said two devices has been formed using the same said at least ten masks.
43. A method according to clause 42, comprising the step of formation of dice lines by etching pre-patterned layers.
44. A method according to clause 42, wherein at least one of said two devices comprises unused potential dice lines.
45. A method according to clause 42, wherein the formation of at least one of said two devices comprises the step of using custom mask to form connection over unused potential dice lines, and wherein the formation of the other of said two devices does not use said custom mask.
46. A method according to clause 42, wherein at least one of said two devices comprises at least two micro-control-units (MCUs), and wherein said two micro-control-units comprise fixed interconnection between them.
47. A method according to clause 42, comprise the step of forming Through Silicon Vias (TSV) to form connection between said second transistors and said first transistors.

## Claims

1. A method for fabrication of a 3D semiconductor device, the method comprising:
providing a substrate comprising a single crystal layer;
forming a plurality of first transistors in and on said single crystal layer; then
forming at least one metal layer, said at least one metal layer comprising connections between said first transistors,
wherein a portion of said at least one metal layer comprising connections between said first transistors forms peripheral circuits; then
forming a stack of at least six layers,
wherein said stack of at least six layers comprises odd numbered layers and even numbered layers,
wherein said odd numbered layers comprise a first material and said even numbered layers comprise a second material,
wherein said first material is of a different composition than said second material, and
wherein said forming a stack is performed as part of forming a multilevel memory structure; and then
processing said stack of at least six layers forming at least three layers of memory cells,
wherein each of said memory cells comprise at least one of a plurality of second transistors, and
wherein said at least three layers of memory cells are controlled by said periphery circuits.

2. The method according to claim 1,
wherein at least said forming a stack of at least six layers and said processing said stack of at least six layers comprises forming a staircase structure, and
wherein said staircase structure comprises a portion of connection paths from said peripheral circuits to at least one of said memory cells.

3. The method according to claim 1,
wherein said processing said stack of at least six layers comprises annealing of said first transistors.

4. The method according to claim 1,
wherein said at least one of said plurality of second transistors comprises a source, a channel, and a drain, and
wherein said source, said channel, and said drain have the same dopant type.

5. The method according to claim 1,
wherein said processing said stack of at least six layers comprises forming metal layers as part of forming connections between said periphery circuits and said memory cells.

6. The method according to claim 1,
wherein said memory cells are part of a non-volatile NAND memory.

7. The method according to claim 1,
wherein said processing said stack of at least six layers comprises Atomic Layer Deposition (ALD).

8. The method according to claim 1,
wherein said processing said stack of at least six layers comprises etching said stack during the same processing etch step and following the same lithographic step.

9. The method according to claim 1,
wherein said second transistors are aligned to said first transistors with less than 40 nm misalignment.

10. A 3D semiconductor device, the device comprising:
a plurality of first transistors, overlaid by a plurality of second memory cells, overlaid by a plurality of third memory cells, overlaid by a plurality of fourth memory cells,
wherein said second memory cells, said third memory cells and said fourth memory cells are self-aligned, having been processed following the same lithography step, and wherein a periphery circuit comprises at least one of said first transistors and said periphery circuit controls at least one of said second memory cells, at least one of said third memory cells and at least one of said fourth memory cells, and
wherein at least one of said second memory cells comprises second transistors, at least one of said second transistors is a junction-less transistor.

11. The device according to claim 10,
wherein said third memory cells comprise at least one junction-less transistor, and wherein said at least one junction-less transistor comprises a polysilicon channel.

12. The device according to claim 10,
wherein said periphery circuit is also called 'control circuit'.

13. The device according to claim 10,
wherein at least one of said second memory cells is at least partially directly overlaying said at least one of said first transistors.

14. The device according to claim 10, further comprising:
a staircase structure,
wherein said staircase structure comprises a portion of connection paths from said periphery circuit to at least one of said memory cells.

15. The device according to claim 10,
wherein said memory cells are part of a non-volatile NAND memory.

16. The device according to claim 10,
wherein said second transistors are aligned to said first transistor with less than 40 nm misalignment.

17. A mobile system comprising a semiconductor device, the device comprising:
a plurality of first transistors, overlaid by a plurality of second memory cells, overlaid by a plurality of third memory cells, overlaid by a plurality of fourth memory cells,
wherein said second memory cells, said third memory cells and said fourth memory cells are self-aligned, having been processed following the same lithography step, and wherein at least one of said first transistors is part of a periphery circuit controlling at least one of said second memory cells, at least one of said third memory cells and at least one of said fourth memory cells, and
wherein at least one of said second memory cells comprises second transistors, at least one of said second transistors is a junction-less transistor.

18. The mobile system according to claim 17,
wherein said third memory cells comprise at least one junction-less transistor, and wherein said at least one junction-less transistor comprises a polysilicon channel.

19. The mobile system according to claim 17,
wherein said periphery circuit is also called 'control circuit'.

20. The mobile system according to claim 17,
wherein at least one of said second memory cells is at least partially directly overlaying said at least one of said first transistors.

21. The mobile system according to claim 17, further comprising:
a staircase structure,
wherein said staircase structure comprises a portion of connection paths from said periphery circuit to at least one of said memory cells.

22. The mobile system according to claim 17,
wherein said memory cells are part of a non-volatile NAND memory.

23. The mobile system according to claim 17,
wherein said second transistors are aligned to said first transistors with less than 40 nm misalignment.
